# EUROPEAN PATENT APPLICATION

(11) **EP 4 478 563 A1**
(43) Date of publication of application: **18.12.2024**
(21) Application number: 23752822.9
(22) Date of filing: 06.02.2023
(51) Int. Cl.: H01S 5/02355, H01L 21/02, H01L 21/50, H01L 21/52, H01S 5/0234, H01S 5/22, H01S 5/40

(54) **LASER ELEMENT PRODUCTION DEVICE AND PRODUCTION METHOD**

(30) Priority: 10.02.2022 JP 2022019834
(71) Applicant: Kyocera Corporation, Kyoto-shi, Kyoto 612-8501 (JP)
(72) Inventor: KAWAGUCHI, Yoshinobu, Kyoto-shi, Kyoto 612-8501 (JP); MURAKAWA, Kentaro, Kyoto-shi, Kyoto 612-8501 (JP); KAMIKAWA, Takeshi, Kyoto-shi, Kyoto 612-8501 (JP)
(74) Representative: Viering, Jentschura & Partner mbB Patent- und Rechtsanwälte
(86) International application number: PCT/JP2023/003770
(87) International publication number: WO 2023/153358

(57) **Abstract**

A laser element manufacturing method includes preparing a semiconductor substrate including a base substrate and a plurality of laminate bodies having a bar shape arranged side by side in a first direction above the base substrate, forming a resonator end surface by splitting each laminate body into a plurality of laser bodies arranged in a second direction orthogonal to the first direction without dividing the base substrate, and selectively transferring some of the plurality of laser bodies obtained from the plurality of laminate bodies to the first substrate.

## Description

### TECHNICAL FIELD

The present disclosure relates to a laser element manufacturing method, and the like.

### BACKGROUND OF INVENTION

Downsizing of a semiconductor device such as a semiconductor laser element makes handling of the semiconductor device difficult. Patent Document 1 describes a technique related to handleability of a semiconductor laser element.

### CITATION LIST

### PATENT LITERATURE

Patent Document 1: JP 2008-252069 A

### SUMMARY

A laser element manufacturing method according to one aspect of the present disclosure includes:
preparing a semiconductor substrate including a base substrate and a plurality of laminate bodies having a bar shape and arranged side by side in a first direction above the base substrate; forming a resonator end surface by splitting each laminate body into a plurality of laser bodies arranged in a second direction orthogonal to the first direction without dividing the base substrate; and selectively transferring, to a first substrate, a part of a plurality of laser bodies obtained from the plurality of laminate bodies.

A laser element manufacturing method according to one aspect of the present disclosure includes: preparing a semiconductor substrate including a base substrate and a plurality of laminate bodies having a bar shape arranged side by side in a first direction above the base substrate; transferring the plurality of laminate bodies having a bar shape to a first tape once and then transferring to a second tape; forming a resonator end surface by splitting each laminate body into a plurality of laser bodies arranged in a second direction orthogonal to the first direction without dividing the second tape; and selectively transferring, to a first substrate, a part of a plurality of laser bodies obtained from the plurality of laminate bodies.

### BRIEF DESCRIPTION OF THE DRAWINGS

FIG. 1 is a flowchart schematically illustrating a laser element manufacturing method in one embodiment of the present disclosure.
FIG. 2 is a perspective view schematically illustrating the laser element manufacturing method in one embodiment of the present disclosure.
FIG. 3 is a cross-sectional view schematically illustrating the laser element manufacturing method in one embodiment of the present disclosure.
FIG. 4 is a perspective view illustrating a configuration of a laser body in Example 1.
FIG. 5 is a plan view illustrating a configuration of a second semiconductor.
FIG. 6 is a cross-sectional view illustrating a configuration of the laser body in Example 1.
FIG. 7 is a flowchart schematically illustrating a laser element manufacturing method in Example 1.
FIG. 8 is a cross-sectional view schematically illustrating the laser element manufacturing method in Example 1.
FIG. 9 is a cross-sectional view taken along line IX-IX illustrated in FIG. 8 as viewed in a direction of arrows.
FIG. 10 is a cross-sectional view illustrating a configuration example of a template substrate.
FIG. 11 is a cross-sectional view illustrating an example of lateral growth of a first semiconductor.
FIG. 12A is a cross-sectional view illustrating an example of a method of scribing and cleaving a laminate body.
FIG. 12B is a cross-sectional view illustrating an example of the method of scribing and cleaving a laminate body.
FIG. 13 is a cross-sectional view taken along line XIII-XIII illustrated in FIG. 12A as viewed in a direction of arrows.
FIG. 14 is a plan view illustrating an example of a configuration of a support substrate.
FIG. 15 is a view for explaining a scene of an example of selective transfer, and is a plan view illustrating a semiconductor substrate and a support substrate.
FIG. 16 is a perspective view schematically illustrating a laser substrate with a plurality of laser bodies joined to a support substrate.
FIG. 17 is a cross-sectional view schematically illustrating a laser body joined to the support substrate.
FIG. 18 is a perspective view illustrating an example of a laser substrate having a bar shape after division.
FIG. 19 is a perspective view illustrating a configuration of a laser element in Example 1.
FIG. 20 is a block diagram illustrating a laser element manufacturing device in Example 1.
FIG. 21 is a flowchart schematically illustrating another example of a laser element manufacturing method in Example 1.
FIG. 22 is a plan view schematically illustrating another example of the laser element manufacturing method in Example 1.
FIG. 23 is a cross-sectional view schematically illustrating another example of the laser element manufacturing method in Example 1.
FIG. 24 is a flowchart schematically illustrating another example of the laser element manufacturing method in Example 1.
FIG. 25 is a plan view schematically illustrating another example of the laser element manufacturing method in Example 1.
FIG. 26 is a cross-sectional view schematically illustrating the laser body joined to the support substrate.
FIG. 27 is a flowchart schematically illustrating a laser element manufacturing method in Example 2.
FIG. 28 is a plan view schematically illustrating the laser element manufacturing method in Example 2.
FIG. 29 is a flowchart schematically illustrating another example of the laser element manufacturing method in Example 2.
FIG. 30 is a plan view schematically illustrating another example of the laser element manufacturing method in Example 2.
FIG. 31 is a flowchart schematically illustrating a laser element manufacturing method in Example 3.
FIG. 32 is a plan view schematically illustrating the laser element manufacturing method in Example 3.
FIG. 33 is a flowchart schematically illustrating a laser element manufacturing method in Example 4.
FIG. 34 is a cross-sectional view schematically illustrating the laser element manufacturing method in Example 4.

### DESCRIPTION OF EMBODIMENTS

An embodiment of the present disclosure will be described below with reference to the accompanying drawings. Note that the following description is for better understanding of the gist of the present disclosure and does not limit the present disclosure unless otherwise specified. Unless otherwise specified in present description, "A to B" representing a numerical value range means "equal to or greater than A and equal to or less than B". Shapes and dimensions (length, width, and the like) of configurations illustrated in each of the drawings in the present application do not necessarily reflect actual shapes and dimensions, and are appropriately changed for clarification and simplification of the drawings. In the present description, a semiconductor laser (Laser Diode (LD)) element may be simply called a "laser element".

### Outline of Present Disclosure

First, an outline of a known laser element manufacturing method and a corresponding manufacturing method of the present disclosure will be schematically described as follows.

In general, a known laser element manufacturing method includes the following. That is, first, a growth substrate (e.g., substrate containing an n-type semiconductor) is prepared. After various functional layers (active layers and the like) are formed on the growth substrate, a ridge structure, an electrode, and the like are formed. Thus, a laser wafer having a device structure is prepared. The laser wafer is processed so that the thickness of the growth substrate is reduced, and then the laser wafer is cleaved (primary cleaving) to form a laser bar having an elongated cuboid shape, for example. After the resonator end surface of the laser bar is coated, the laser bar is divided by cleaving (secondary cleaving). Thus, a laser chip is formed. TA chip-on-submount in which the laser chip is bonded to a submount is formed. In such a known method, the laser chip is generally handled using a collet. However, the smaller the dimension of the laser chip is, the worse the handleability of the laser chip is.

On the other hand, a laser element manufacturing method in one embodiment (hereinafter, the present embodiment) of the present disclosure schematically includes the following, although details will be described later. That is, first, a structure (laminate body LB described later) having a device structure is formed on the base substrate. Thereafter, without splitting the base substrate, the structure is split on the base substrate to form a large number of laser bodies (laser chips). The laser body has a resonator end surface. The laser body is transferred from the base substrate to a support substrate having a function as a submount. At this time, some of the large number of laser bodies are selectively transferred (selective transfer) to the support substrate. The resonator end surface of the laser body mounted on the support substrate can be coated. A support substrate (light emitting substrate) mounted with a plurality of laser bodies can be split with an appropriate size. Thus, the chip-on-submount can be formed. In the present description, a chip-on-submount mounted with a laser body may be called a "laser element".

In the manufacturing method of the present embodiment, even when the size of the laser body is small, handleability can be improved by transferring the laser body to the support substrate without directly handling the laser body. A chip-on-submount larger in size than the laser body can be handled by a collet, for example. The individual laser bodies can be formed with a space between adjacent laser bodies on the base substrate, and in this case, the laser bodies can be easily selectively transferred from the base substrate to the support substrate. Various other advantages will be described later together with specific examples.

### Laser Element Manufacturing Method

A laser element manufacturing method in the present embodiment will be described below with reference to the drawings.

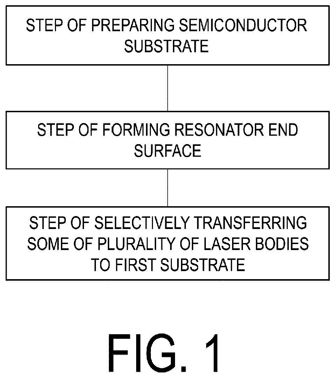

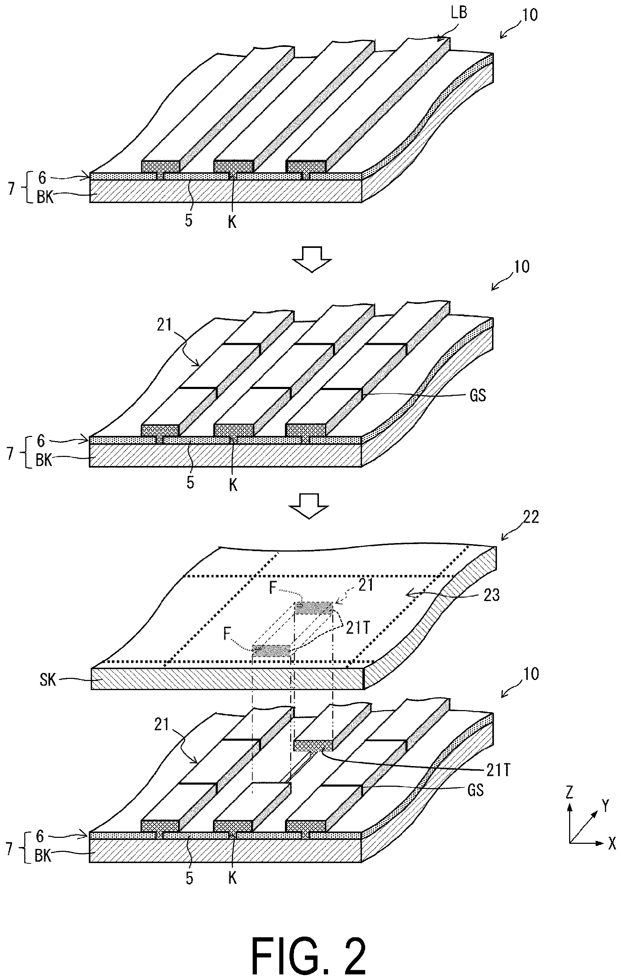

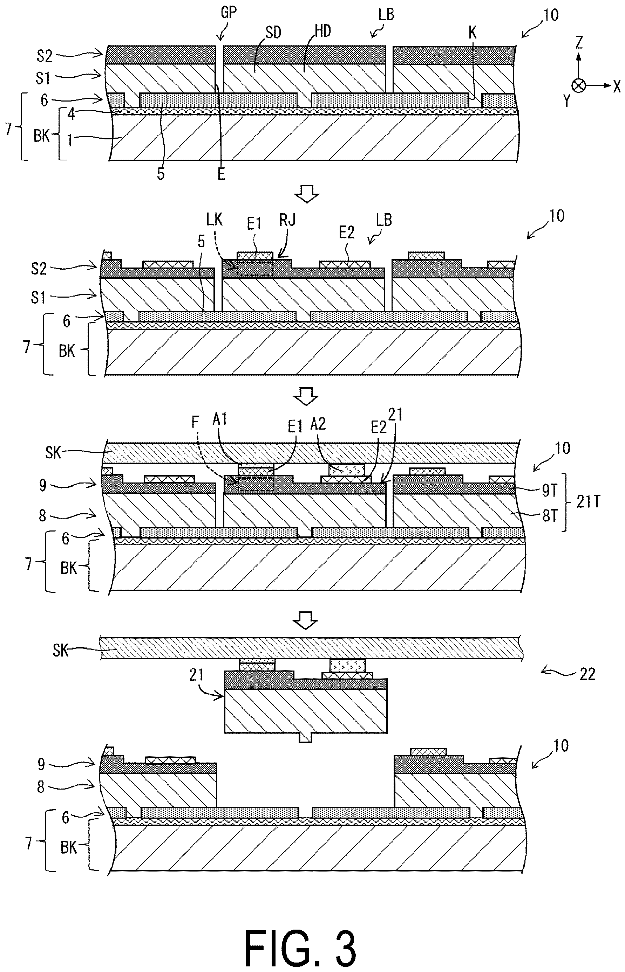

FIG. 1 is a flowchart schematically illustrating the laser element manufacturing method in one embodiment of the present disclosure. FIG. 2 is a perspective view schematically illustrating the laser element manufacturing method in the present embodiment. FIG. 3 is a cross-sectional view schematically illustrating the laser element manufacturing method in the present embodiment. In the present embodiment, a laser element having a ridge structure (ridge waveguide structure) will be described as an example of the laser element. In FIG. 2, for the sake of clarity of illustration, the structure of each part is illustrated in a simplified manner, and illustration of a ridge, an electrode, and the like is appropriately omitted. In FIG. 3, for the sake of clarity of illustration, the structure of each part is simplified and appropriately exaggerated. The third view from the top and the lowermost view in FIG. 3 illustrate the laminate body LB that is split, and are end views (cut portion cross-sectional views) schematically illustrating a surface including an end surface 21T of a laser body 21.

As illustrated in FIGs. 1 to 3, the laser element manufacturing method in the present embodiment includes: preparing a semiconductor substrate 10 including a base substrate BK and a plurality of the laminate bodies LB having a bar shape arranged side by side in an X direction (first direction) above the base substrate BK; forming a resonator end surface F by splitting each laminate body LB into a plurality of laser bodies (light emitters) 21 arranged in a Y direction (second direction) orthogonal to the X direction without dividing the base substrate BK; and selectively transferring some of the plurality of laser bodies 21 obtained from the plurality of laminate bodies LB to a support substrate (first substrate) SK. The base substrate BK may be a crystal growth substrate, and the semiconductor substrate 10 may be prepared in which the plurality of laminate bodies LB having a bar shape are arranged in the X direction in crystalline bonding with the base substrate BK.

The semiconductor substrate 10 in the present embodiment includes the base substrate BK and a mask 6 having a stripe shape. The base substrate BK includes a main substrate 1 and a bed 4 formed on the main substrate 1. The mask 6 is formed above the base substrate BK and has an opening K and a mask portion 5. The base substrate BK and the mask 6 may be called a template substrate 7. The laminate body LB includes a first semiconductor S1 positioned above the base substrate BK and a second semiconductor S2 positioned above the first semiconductor S1. The first semiconductor S1 has a longitudinal shape with the Y direction as a longitudinal direction, and is positioned on the mask 6 from the opening K. The term "on the mask 6" means a region that is above the mask 6, and may mean a portion that is not in contact with the mask 6. The first semiconductor S1 may be a first semiconductor layer, and the second semiconductor S2 may be a second semiconductor layer. The mask 6 may be a mask pattern including the mask portion 5 and the opening K. The opening K is a region where the mask portion 5 does not exist, and the opening K needs not be surrounded by the mask portion 5. The mask portion 5 is a region (growth suppression region) in which the growth of the semiconductor is suppressed in contrast to the opening K.

The semiconductor substrate 10 may be prepared, for example, by performing various types of processing on the template substrate 7, or a semiconductor substrate or the like with the first semiconductor S1 formed on the template substrate 7. A specific method for preparing the semiconductor substrate 10 is not particularly limited as long as the semiconductor substrate 10 where the plurality of laminate bodies LB having a bar shape are formed on the base substrate BK can be prepared.

When the first semiconductor S1 is formed using the ELO method, the template substrate 7 including the main substrate 1 and the mask 6 on the main substrate 1 may be used, and the template substrate 7 may have a growth suppression region (e.g., a region in which crystal growth in a Z direction is suppressed) corresponding to the mask portion 5 and a seed region corresponding to the opening K. For example, the growth suppression region and the seed region can be formed on the main substrate 1, and the first semiconductor S1 can be formed on the growth suppression region and the seed region using the ELO method.

The second semiconductor S2 in the laminate body LB may have a ridge RJ. The laminate body LB may have both a first electrode E1 and a second electrode E2, may have the first electrode E1 and/or the second electrode E2, or needs not have the first electrode E1 and the second electrode E2. After the semiconductor substrate 10 is prepared, the first electrode E1 and the second electrode E2 may be formed after the laminate body LB is split (see examples described later).

The first semiconductor S1 and the second semiconductor S2 may contain a nitride semiconductor (e.g., GaN-based semiconductor). The nitride semiconductor may be expressed by, for example, AlxGayInzN (0 ≤ x ≤ 1; 0 ≤ y ≤ 1; 0 ≤ z ≤ 1; x + y + z = 1). Specific examples of the nitride semiconductor may include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor may include GaN, AlGaN, AlGaInN, and InGaN. The first semiconductor S1 may be a dope type (e.g., n-type including a donor) or a non-dope type (i type).

The first semiconductor S1 containing the nitride semiconductor can be formed using an epitaxial lateral overgrowth (ELO) method on the template substrate 7, for example. In the ELO method, the first semiconductor S1 is grown in the lateral direction on the template substrate 7 having the mask 6 (selective growth mask). The mask 6 may be formed with the opening K having a longitudinal shape extending in the Y direction above the base substrate BK.

The bed 4 includes a seed (not illustrated), and the first semiconductor S1 can be formed by the ELO method with the seed exposed from the opening K as a starting point. In the present embodiment, the first semiconductors S1 may be formed such that the first semiconductors S1 grown from the adjacent seed do not come into contact (associate) with each other on the mask portion 5, and a gap GP is formed between the adjacent first semiconductors S1. The first semiconductor S1 may have an edge (side surface) E in the vicinity of the center of the mask portion 5. The plurality of first semiconductors S1 having a bar shape may be formed by growing the first semiconductors S1 so that the adjacent first semiconductors S1 come into contact (associate) with each other and then removing the associated portions.

In the semiconductor substrate 10, a plurality of layers are laminated on the main substrate 1, and the laminating direction (thickness direction) may be the Z direction orthogonal to the X direction and the Y direction. Viewing the semiconductor substrate 10 with a line of sight parallel to a normal direction of the semiconductor substrate 10 can be called "plan view".

The first semiconductor S1 may have a dislocation inheritor HD positioned on the opening K and a low defect portion SD positioned on the mask portion 5. In the first semiconductor S1, the low defect portion SD may be smaller in density (threading dislocation density) of threading dislocation extending in the thickness direction (Z direction) than the dislocation inheritor HD. Even when the main substrate 1 included in the template substrate 7 is a dissimilar substrate (a substrate having a lattice constant different from that of the first semiconductor S1), the low defect portion SD having a small threading dislocation density can be formed on the mask portion 5. The threading dislocation can be observed by performing, for example, a cathode luminescence (CL) measurement on a surface (c surface) of the first semiconductor S1 and the second semiconductor S2 or a cross section parallel to the surface.

In the second semiconductor S2, a part overlapping the low defect portion SD in plan view has a reduced threading dislocation taken over from the low defect portion SD. An optical resonator LK can be formed in this part, and in this case, the possibility that the performance of the optical resonator LK is deteriorated due to the influence of the threading dislocation can be reduced. As a result, the light emission efficiency and reliability of the laser element can be enhanced. "Two members overlap" means that at least a part of one member overlaps the other member in plan view (including perspective plan view) viewed in the thickness direction of each member, and these members may be in contact with each other or need not be in contact with each other.

The laminate body LB may be formed by removing the dislocation inheritor HD on the opening K. In this case, the first semiconductor S1 may be positioned only on the mask portion 5, and the second semiconductor S2 may be formed above the first semiconductor S1.

The laminate body LB of the present embodiment has a structure (hereinafter, called a "single-sided two-electrode structure") including the first electrode E1 and the second electrode E2 above the second semiconductor S2. The laminate body LB may be provided with the second electrode E2 in contact with the first semiconductor S1 that is partially exposed. The second electrode E2 may be in contact with the n-type semiconductor (described later) in the second semiconductor S2. The first electrode E1 and the second electrode E2 may be formed before the laminate body LB is split, or may be formed after the laminate body LB is split. The ridge RJ that constricts the current may be formed in the second semiconductor S2, and the first electrode E1 may be provided at a position overlapping the ridge RJ in plan view. The structure of the ridge RJ will be described in detail in Example 1 described later.

The laminate body LB may have a structure (hereinafter, called a "double-sided electrode structure") having the first electrode E1 above the second semiconductor S2 and having the second electrode E2 on the side opposite to the side provided with the first electrode E1. For example, after the laser body 21 is transferred to the support substrate SK, the second electrode E2 electrically connected to the first semiconductor S1 may be formed on the surface of the laser body 21 on the side opposite to the side provided with the first electrode E1.

In the laser element manufacturing method in the present embodiment, the laminate body LB is split into the plurality of laser bodies 21 by forming a plurality of open grooves GS in the laminate body LB on the base substrate BK. The open grooves GS may be trenches formed by etching the first semiconductor S1 and the second semiconductor S2. The open grooves GS may be gap spaces formed by cleaving the first semiconductor S1 and the second semiconductor S2. The end surface 21T of the laser body 21 may be formed by forming the open grooves GS. The end surface 21T includes the resonator end surface F.

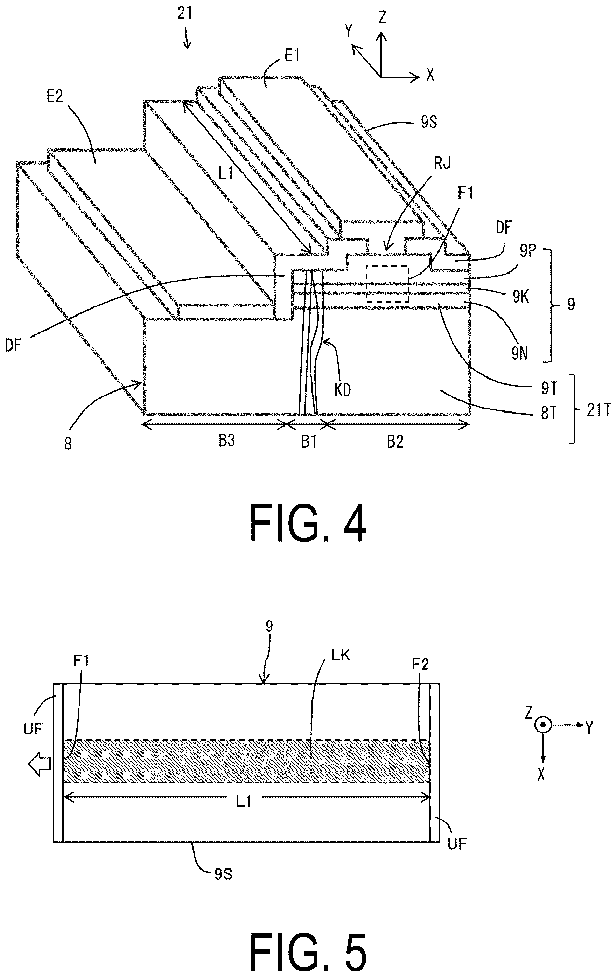

As described later, the laser body 21 includes a base semiconductor 8 and a compound semiconductor 9 (see FIG. 4). By forming the plurality of open grooves GS in the laminate body LB, the first semiconductor S1 may be split into a plurality of base semiconductors 8, and the second semiconductor S2 may be split into a plurality of compound semiconductors 9. The end surface 21T of the laser body 21 includes an end surface 8T of the base semiconductor 8 and an end surface 9T of the compound semiconductor 9.

The open groove GS can be a gap space as follows. That is, when the laser body 21 is selectively transferred to the support substrate SK, a gap space can be provided that reduces the possibility that the end surfaces 21T of the adjacent laser bodies 21 are scratched by rubbing against each other. In particular, a gap space can be provided that reduces the possibility that the resonator end surfaces F of the adjacent laser bodies 21 are scratched by rubbing against each other.

In selectively transferring some of the plurality of laser bodies 21 obtained from the plurality of laminate bodies LB to the support substrate SK, the semiconductor substrate 10 and the support substrate SK are brought close to each other with first and second joints A1 and A2 (e.g., solder) of the support substrate SK being heated and melted. The first and second electrodes E1 and E2 of the laser body 21 and the first and second joints A1 and A2 are joined to each other, respectively. Subsequently, by separating the semiconductor substrate 10 and the support substrate SK from each other, a coupler (downward protrusion) with the base substrate BK on the back surface of the base semiconductor 8 is ruptured, and the laser body 21 is separated from the template substrate 7. After the mask 6 is removed by etching or the like, the laser body 21 may be selectively transferred to the support substrate SK.

Since the semiconductor substrate 10 has the open groove GS and the gap GP, the laser body 21 can be easily transferred to the support substrate SK. FIGs. 2 and 3 illustrate a scene in which one laser body 21 is transferred to the support substrate SK, but the plurality of laser bodies 21 can be simultaneously transferred to and mounted on the support substrate SK. Thus, a laser substrate 22 mounted with the plurality of laser bodies 21 can be formed. The support substrate SK in the laser substrate 22 can be split into appropriate sizes to form a laser element 23 in which one or more laser bodies 21 are mounted on a support body. A specific element structure in the laser element 23 is not particularly limited.

As described above, according to the laser element manufacturing method in the present embodiment, direct handling of the laser body 21 is not necessary. Therefore, even when the size of the laser body 21 is small, the laser substrate 22 or the laser element 23 larger in size than the laser body 21 can be handled. Therefore, handleability in the process of producing the laser element can be improved.

### Example 1

Hereinafter, one example of the present disclosure will be described in detail. In the following description, in order to facilitate understanding of the laser element manufacturing method in Example 1, the configuration of the laser body included in the laser element of Example 1 and the configuration of the laser element in which the laser body is mounted on a support body will be described first.

### Laser Body

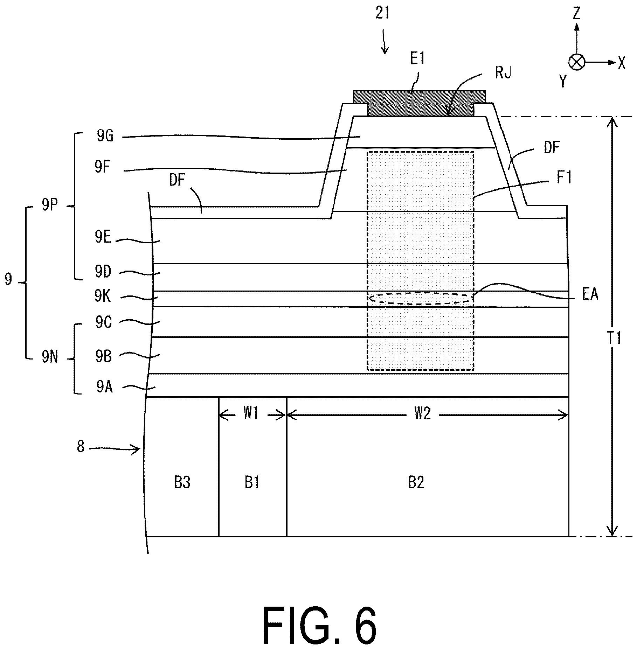

FIG. 4 is a perspective view illustrating the configuration of the laser body in Example 1. FIG. 5 is a plan view illustrating the configuration of the second semiconductor. FIG. 6 is a cross-sectional view illustrating the configuration of the laser body in Example 1. FIGs. 4 to 6 are appropriately referred to also in the description of the laser element manufacturing method described later.

As illustrated in FIGs. 4 to 6, the laser body 21 in Example 1 includes the base semiconductor 8, the compound semiconductor 9 positioned on the base semiconductor 8 and including the optical resonator LK, the first electrode E1, which is an anode, and the second electrode E2, which is a cathode. The laser body 21 can also be called a semiconductor laser chip. The base semiconductor 8 and the compound semiconductor 9 may be parts of the first semiconductor S1 and the second semiconductor S2, respectively in the laminate body LB described above.

The base semiconductor 8 and the compound semiconductor 9 may be a nitride semiconductor layer (e.g., a GaN-based semiconductor layer), and the base semiconductor 8 may be an n-type semiconductor layer containing a donor. In FIG. 4 and the like, the X direction is the <11-20> direction (a-axis direction) of the nitride semiconductor crystal (wurtzite structure), the Y direction is the <1-100> direction (m-axis direction) of the nitride semiconductor crystal, and the Z direction is the <0001> direction (c-axis direction) of the nitride semiconductor crystal.

The laser body 21 may be positioned on a growth substrate (e.g., the template substrate 7) or may be mounted on a mounting substrate such as the support substrate SK, and in FIG. 4 and the like, the growth substrate or the mounting substrate is omitted.

The base semiconductor 8 includes a first portion B 1 having a threading dislocation KD extending in the thickness direction (Z direction), and a second portion B2 and a third portion B3 having the density (threading dislocation density) of the threading dislocations KD smaller than that of the first portion B 1. The third portion B3, the first portion B, and the second portion B2 are arranged in this order in the X direction, and the first portion B 1 is positioned between the third portion B3 and the second portion B2. The first portion B 1 is a part positioned on the opening K of the mask 6 when the first semiconductor S1 is formed by the ELO method. The first portion B 1 may be a part corresponding to the dislocation inheritor HD described above, and the second portion B2 and the third portion B3 may be parts corresponding to the low defect portion SD described above.

The compound semiconductor 9 includes an n-type semiconductor 9N having a donor, an active portion 9K, and a p-type semiconductor 9P having an acceptor that are formed in this order. The n-type semiconductor 9N may include a first contact 9A, a first cladding 9B, and a first light guide 9C that are formed in this order. The p-type semiconductor 9P may include a second light guide 9D, an electron blocking 9E, a second cladding 9F, and a second contact 9G that are formed in this order, and the first electrode E1 (anode) may be formed on the second contact 9G. Note that the compound semiconductor 9 may have the second light guide 9D and the electron blocking 9E exchanged with each other in the p-type semiconductor 9P. For example, the p-type semiconductor 9P may include the electron blocking 9E, the second light guide 9D, the second cladding 9F, and the second contact 9G that are formed in this order.

In Example 1, the second electrode E2 is provided on the same side as the first electrode E1 with respect to the base semiconductor 8. The second electrode E2 is in contact with the base semiconductor 8, and the first and second electrodes E1 and E2 do not overlap in plan view. Specifically, the base semiconductor 8 may have a width larger in the X direction than the compound semiconductor 9, and the second electrode E2 may be formed in the exposed part of the base semiconductor 8. In preparing the semiconductor substrate 10 having the laminate body LB, the first contact 9A in the second semiconductor S2 may be exposed by etching or the like a part of the second semiconductor S2, and in this case, the second electrode E2 may be provided in contact with the first contact 9A.

The compound semiconductor 9 has the optical resonator LK including a pair of resonator end surfaces F1 and F2. A resonator length L1, which is the distance between the pair of resonator end surfaces F1 and F2, may be 200 [µm] or less, may be 150 [µm] or less, or may be 100 [µm] or less. The lower limit of the resonator length L1 is not particularly limited as long as the optical resonator LK can function, and may be 50 [µm], for example. The resonator end surfaces F1 and F2 may each be an m-plane of the nitride semiconductor crystal of the second semiconductor S2. The resonator end surfaces F1 and F2 may be included in cleavage surfaces of the first semiconductor S1 and the second semiconductor S2 (the end surface 21T of the laser body 21), respectively. That is, the resonator end surfaces F1 and F2 can be formed by cleaving, in the m-plane, the first semiconductor S1 and the second semiconductor S2, which are nitride semiconductor layers (e.g., GaN-based semiconductor layers).

After the laser body 21 is selectively transferred to the support substrate SK, a reflector film UF (e.g., a dielectric film) covering each of the resonator end surfaces F1 and F2 may be formed. The light reflectance of the resonator end surface F1 on the light emitting surface side may be 80% or more and may be 98% or more. The light reflectance of the resonator end surface F2 on the light reflecting surface side is larger than the light reflectance of the resonator end surface F1. Although not illustrated in FIG. 4, the reflector film UF can be formed on the entire cleavage surfaces (m-planes) of the first semiconductor S1 and the second semiconductor S2.

The first electrode E1 overlaps the optical resonator LK in plan view and overlaps the second portion B2 of the base semiconductor 8. The first electrode E1 may have a shape in which the direction of the resonator length (Y direction) is the longitudinal direction.

The compound semiconductor 9 includes the ridge RJ overlapping the first electrode E1 in plan view, and the ridge RJ includes the second cladding 9F and the second contact 9G. The ridge RJ has a shape in which the Y direction is the longitudinal direction, and is provided with an insulation film DF to cover a side surface of the ridge RJ. Both end parts in the X direction of the first electrode E1 may overlap the insulation film DF in plan view.

### Laser Element Manufacturing Method

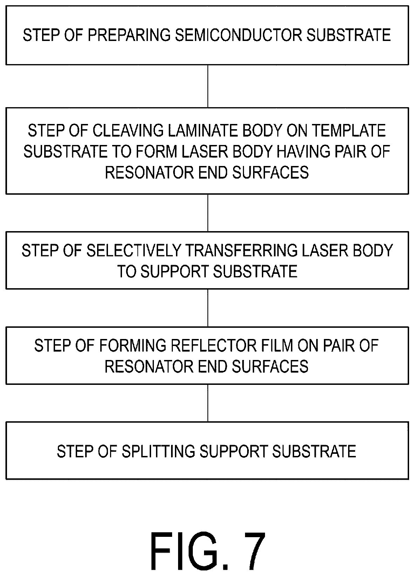

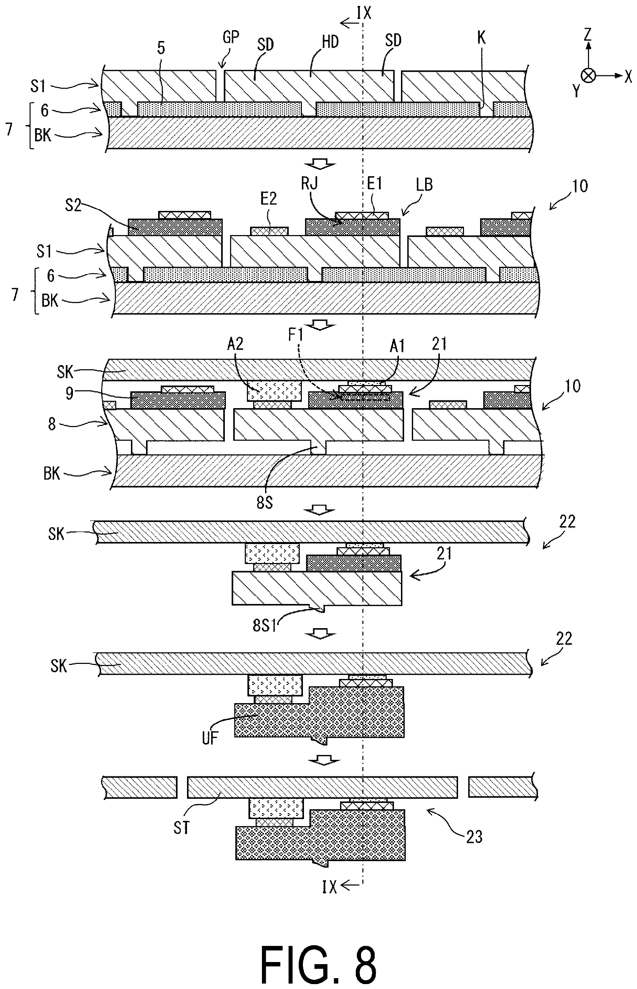

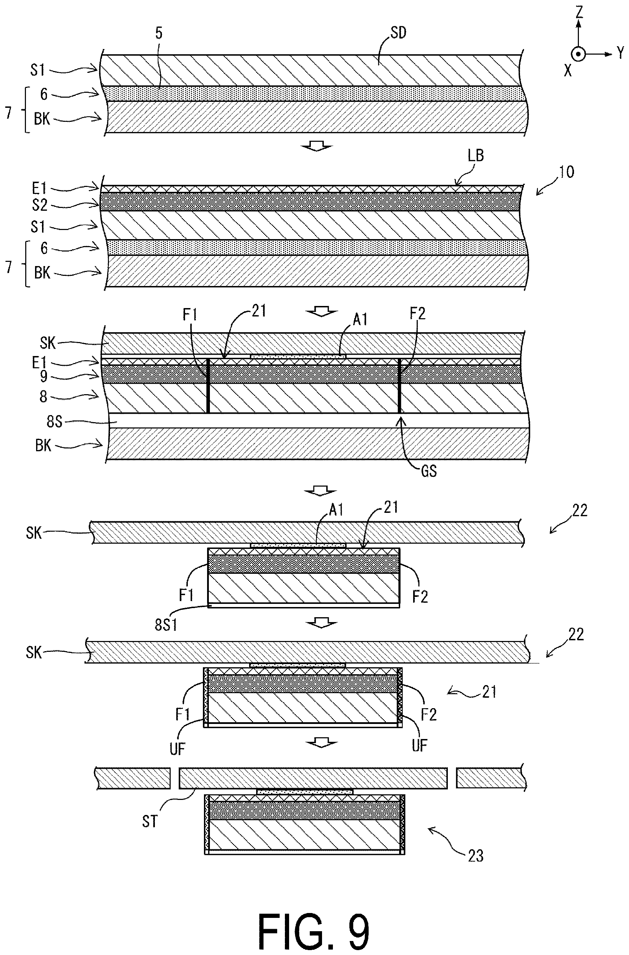

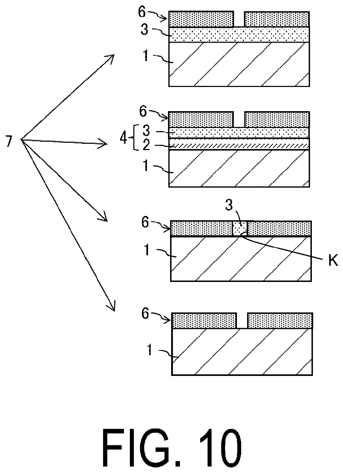

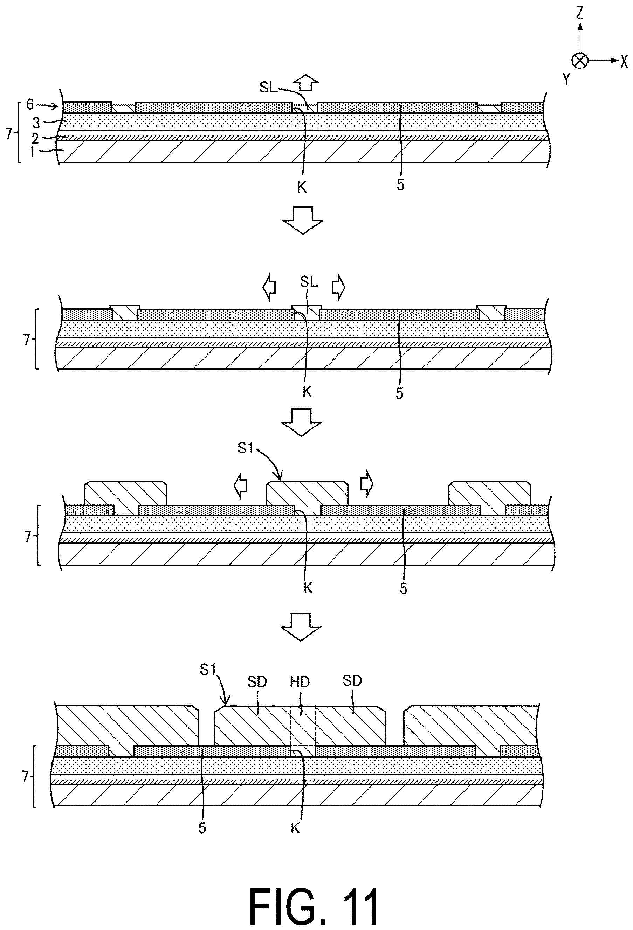

FIG. 7 is a flowchart schematically illustrating the laser element manufacturing method in Example 1. FIG. 8 is a cross-sectional view schematically illustrating the laser element manufacturing method in Example 1. FIG. 9 is a cross-sectional view taken along line IX-IX illustrated in FIG. 8 as viewed in the direction of arrows. FIG. 10 is a cross-sectional view illustrating a configuration example of the template substrate. FIG. 11 is a cross-sectional view illustrating an example of lateral growth of the first semiconductor. FIGs. 8 and 9 are schematically illustrated with details of the structure of the laminate body LB and the like omitted. Note that in FIG. 8, among the plurality of drawings illustrated from the top to the bottom along the flow of processing, for convenience of description, the third view from the top and subsequent views illustrate the end surface of the laser body 21.

In the laser element manufacturing method of Example 1, the semiconductor substrate 10 is prepared first as illustrated in FIGs. 7 to 9. In the semiconductor substrate 10, the plurality of laminate bodies LB having a bar shape including the first semiconductor S1 and the second semiconductor S2 may be formed on the template substrate 7. Hereinafter, an example in which the semiconductor substrate 10 is prepared by performing various processing on the template substrate 7 will be described, but the present invention is not limited to this. It is also within the scope of the present disclosure to prepare the semiconductor substrate 10 of Example 1 by processing a semi-finished product of the semiconductor substrate 10 in the middle stage of forming the semiconductor substrate 10 from the template substrate 7. This will not be described repeatedly, and the same applies to the following examples.

### Template Substrate

The template substrate 7 includes the base substrate BK and the mask 6 positioned above the base substrate BK.

As illustrated in FIG. 10, the template substrate 7 may have a configuration in which the seed 3 and the mask 6 are formed in this order on the main substrate 1, or a configuration in which a plurality of layers of the beds 4 (including a buffer 2 and the seed 3) and the mask 6 are formed in this order on the main substrate 1. The seed 3 may be locally (e.g., in a stripe shape) formed to overlap the opening K of the mask 6 in plan view. The seed 3 may include a nitride semiconductor formed at a low temperature of 600°C or lower. This can reduce the warpage of the semiconductor substrate 10 (the template substrate 7 and the laminate body LB) caused by the stress of the seed 3. The seed 3 can also be formed using a sputtering device (pulse sputter deposition: PSD, pulse laser deposition: PLD, and the like). Use of the sputtering device has advantages that low-temperature film formation and large-area film formation are possible, cost reduction can be achieved, and the like. As illustrated in FIG. 10, the template substrate 7 may have a configuration in which the mask 6 is formed on the main substrate 1(e.g., a SiC bulk crystal substrate or a GaN bulk crystal substrate).

As described above, the base substrate BK may include at least the main substrate 1. The base substrate BK may include the main substrate 1 and the seed 3 positioned above the main substrate 1, and may include the main substrate 1 and the bed 4 positioned above the main substrate 1. A dissimilar substrate having a different lattice constant from that of the GaN-based semiconductor may be used for the main substrate 1. Examples of the dissimilar substrate include a single crystal silicon (Si) substrate, a sapphire (Al₂O₃) substrate, and silicon carbide (SiC) substrate. The plane direction of the main substrate 1 is, for example, the (111) plane of the silicon substrate, the (0001) plane of the sapphire substrate, or the 6H-SiC

(0001) plane of the SiC substrate. These are merely examples, and any main substrate and any plane direction may be used as long as the first semiconductor S1 can be grown by the ELO method. A SiC (bulk crystal) substrate, a GaN (bulk crystal) substrate, or an AlN (bulk crystal) substrate can be used as the main substrate 1.

As the bed 4 in FIG. 10, the buffer 2 and the seed 3 can be provided in this order from the main substrate 1 side. For example, use of a silicon substrate for the main substrate 1 and use of a GaN-based semiconductor for the seed 3 make both (the main substrate and the seed) melt with each other, and therefore, for example, the buffer 2 including an AlN layer and/or a silicon carbide (SiC) layer is provided, thereby reducing the possibility that melting of the main substrate 1 and the seed 3 occurs. The buffer 2 may have an effect of enhancing the crystallinity of the seed 3 and/or an effect of relaxing the internal stress of the first semiconductor S1. Use of the main substrate 1 unlikely to melt with the seed 3 enables a configuration not provided with the buffer 2. Note that the configuration is not limited to the one in which the seed 3 overlaps the entire mask portion 5 as illustrated in FIG. 10. Since the seed 3 may be exposed from the opening K, the seed 3 may be locally formed not to overlap a part or the entirety of the mask portion 5.

The opening K of the mask 6 has a function of a growth start hole for exposing the seed 3 and starting the growth of the first semiconductor S1, and the mask portion 5 of the mask 6 has a function of a selective growth mask for laterally growing the first semiconductor S1.

As the mask 6, for example, a single-layer film including any one of a silicon oxide film (SiOx), a titanium nitride film (TiN or the like), a silicon nitride film (SiNx), a silicon oxynitride film (SiON), and a metal film having a high melting point (e.g., 1000 degrees or more), or a laminated film including at least two selected from the group consisting of them can be used.

For example, a silicon oxide film having a thickness of from about 100 nm to about 4 µm (preferably from about 150 nm to about 2 µm) is formed on the entire surface of the seed 3 by using sputtering, and a resist is applied onto the entire surface of the silicon oxide film. Subsequently, the resist is patterned by photolithography to form the resist with a plurality of stripe-shaped openings. Subsequently, a part of the silicon oxide film is removed by wet etchant such as hydrofluoric acid (HF) or buffered hydrofluoric acid (BHF) to form a plurality of openings K, and the resist is removed by organic cleaning to form the mask 6. As another example, the silicon nitride film may be formed using a sputtering device or a plasma enhanced chemical vapor deposition (PECVD) device. The silicon nitride film can withstand a film formation temperature (about 1000°C) of the base semiconductor 8 even if it is thinner than the silicon oxide film. The thickness of the silicon nitride film can be set to from about 5 nm to about 4 µm.

The openings K having the longitudinal shape (slit shape) can be periodically arrayed in the X direction. The width of the opening K may be set to from about 0.1 µm to about 20 µm. The smaller the width of the opening K is, the larger the widths (sizes in the X direction) of the second portion B2 and the third portion B3 (low defect portion SD) can be.

The silicon oxide film may be decomposed and evaporated in a small amount during film formation of the first semiconductor S1 and may be taken into the first semiconductor S1, but the silicon nitride film and the silicon oxynitride film have an advantage in terms of hardly decomposing and evaporating at a high temperature. The mask portion 5 may be a single-layer film of the silicon nitride film or the silicon oxynitride film. The mask portion 5 may be a laminated film in which the silicon oxide film and the silicon nitride film are formed in this order on the seed 3. The mask portion 5 may be a laminate body film in which the silicon nitride film and the silicon oxide film are formed in this order on the seed 3. The mask portion 5 may be a laminated film in which the silicon nitride film, the silicon oxide film, and the silicon nitride film are formed in this order on the bed 4. A desired oxynitride film may be formed by controlling compositions of oxygen and nitrogen of SiON.

An abnormal portion such as a pinhole in the mask portion 5 may be eliminated by performing organic cleaning or the like after film formation and introducing the film again into a film forming device to form the same type of film. A typical silicon oxide film (single layer) can also be used to form the mask 6 having a good quality by such a method to form the film again.

In Example 1, as an example of the template substrate 7, a silicon substrate (e.g., a 2 inch Si substrate) having the (111) plane can be used for the main substrate 1, an AlN layer (about 30 nm to 300 nm, for example, 150 nm) can be used for the buffer 2, a GaN-based graded layer can be used for the seed 3, and a laminated mask in which a silicon oxide film (SiO2) and a silicon nitride film (SiN) are formed in this order can be used for the mask 6. The GaN-based graded layer may include an Al_{0.6}Ga_{0.4}N layer (e.g., 300 nm) that is a first layer and a GaN layer (e.g., from 1 µm to 2 µm) that is a second layer. For the mask 6, a plasma chemical vapor deposition method (CVD method) can be used for formation of each of the silicon oxide film and the silicon nitride film, and the thickness of the silicon oxide film can be set to, for example, 0.3 µm and the thickness of the silicon nitride film can be set to, for example, 70 nm. The width (size in the X direction) of the mask portion 5 can be 50 µm, and the width (size in the X direction) of the opening K can be 5 µm.

### First Semiconductor

In Example 1, the first semiconductor S1 serving as a base of the base semiconductor 8 is formed on the template substrate 7 using the ELO method. In Example 1, an ELO film of gallium nitride (GaN) is formed on the template substrate 7 using a metal-organic chemical vapor deposition (MOCVD) device with the first semiconductor S1 as a GaN layer. The following may be adopted as examples of the ELO film formation conditions: substrate temperature: 1120°C, growth pressure: 50 kPa, trimethylgallium (TMG): 22 sccm, NH₃: 15 slm, and V/III = 6000 (ratio of group V raw material supply amount to group III raw material supply amount).

In this case, the first semiconductor S1 is selectively grown (longitudinally grown) on the seed 3 exposed from the opening K and is subsequently laterally grown on the mask portion 5. The lateral growth is stopped before GaN crystal films laterally grown from both sides on the mask portion 5 are associated with each other. In Example 1, the growth is stopped before the semiconductor crystals (e.g., GaN-based crystals) growing and coming close to each other on the mask portion 5 are associated with each other, whereby the plurality of first semiconductors S1 are formed. Accordingly, the gap GP is formed between the first semiconductors S1 adjacent to each other in the X direction. The X direction may be the <11-20> direction (a-axis direction) of the GaN-based crystal, the Y direction may be the <1-100> direction (m-axis direction) of the GaN-based crystal, and the Z direction may be the <0001> direction (c-axis direction) of the GaN-based crystal.

In the formation of the first semiconductor S1 in Example 1, a longitudinal growth layer that grows in the Z direction (c-axis direction) is formed on the seed 3 exposed from the opening K, and then a lateral growth layer that grows in the X direction (a-axis direction) is formed. At this time, by setting the thickness of the longitudinal growth layer to 10 µm or less, 5 µm or less, or 3 µm or less, the thickness of the lateral growth layer can be suppressed to be low, and the lateral film formation rate can be increased.

FIG. 11 is a cross-sectional view illustrating an example of lateral growth of the first semiconductor (ELO semiconductor layer). As illustrated in FIG. 11, an initial growth portion SL may be formed on the seed 3 (GaN layer of an upper layer portion) exposed from the opening K, and then the first semiconductor S1 may be laterally grown from the initial growth portion SL. The initial growth portion SL serves as a starting point of lateral growth of the first semiconductor S 1. The first semiconductor S1 can be controlled to grow in the Z direction (c-axis direction) or grow in the X direction (a-axis direction) by appropriately controlling the ELO film formation conditions.

Here, the film formation of the initial growth portion SL may be stopped at a timing immediately before the edge of the initial growth portion SL rides on the upper surface of the mask portion 5 (a stage of being in contact with the upper end of the side surface of the mask portion 5) or immediately after the edge of the initial growth portion SL rides on the upper surface of the mask portion 5 (i.e., at this timing, the ELO film formation condition may be switched from the c-axis direction film formation condition to the a-axis direction film formation condition). In this way, since the lateral film formation is performed from the state in which the initial growth portion SL slightly protrudes from the mask portion 5, consumption of the material for the growth in the thickness direction of the first semiconductor S1 can be reduced, and the first semiconductor S1 can be grown laterally at a high speed. The initial growth portion SL can have a thickness of, for example, 0.5 µm or more and 4.0 µm or less.

The threading dislocation density of the low defect portion SD (corresponding to the second portion B2 or the third portion B3 of the base semiconductor 8) in the first semiconductor S1 may be 1/5 or less (e.g., 5 × 10⁶/cm² or less) of the threading dislocation density of the dislocation inheritor HD (corresponding to the first portion B1 of the base semiconductor 8) in the first semiconductor S1. Here, the threading dislocation density can be obtained, for example, by performing CL measurement on the surface of the first semiconductor S1 (e.g., counting the number of black spots). The dislocation density can be expressed in units of [quantity/cm²], and, in the present description, may be expressed as [/cm²] with the quantity omitted. The basal plane dislocation density of the low defect portion SD may be 5 × 10⁸/cm² or less. The basal plane dislocation may be a dislocation extending in an in-plane direction of the c-plane (X-Y plane) of the first semiconductor S1. Here, the basal plane dislocation density is obtained, for example, by splitting the first semiconductor S1 to expose the side surface of the low defect portion SD and performing CL measurement of the dislocation density of this side surface.

The lateral width (size in the X direction) of the first semiconductor S1 was 53 µm, the width (size in the X direction) of the low defect portion SD was 24 µm, and the layer thickness (size in the Z direction) of the first semiconductor S1 was 5 µm. The aspect ratio of the first semiconductor S1 was 53 µm/5 µm = 10.6, and a very high aspect ratio was achieved. The width of the mask portion 5 can be set in accordance with specifications of the compound semiconductor 9 and the like (e.g., from about 10 µm to about 200 µm). In Example 1, the adjacent first semiconductors S1 are not associated with each other, the plurality of first semiconductors S1 having a bar shape are formed side by side in the X direction on the template substrate 7, and the lateral width (size in the X direction) of the gap GP is about 5 µm.

### Second Semiconductor

In the laser element manufacturing method of Example 1, next, the second semiconductor S2 serving as the base of the compound semiconductor 9 is formed above the first semiconductor S 1. The second semiconductor S2 can be formed by, for example, the MOCVD method. As described above, the second semiconductor S2 includes the n-type semiconductor 9N, the active portion 9K, and the p-type semiconductor 9P. The active portion 9K, each portion included in the n-type semiconductor 9N, and each portion included in the p-type semiconductor 9P may each have a layer shape (e.g., the active portion 9K may be an active layer).

For example, an n-type GaN layer can be used for the first contact 9A, for example, an n-type AlGaN layer can be used for the first cladding 9B, for example, an n-type GaN layer can be used for the first light guide 9C, a multi-quantum well (MQW) structure including an InGaN layer, for example, can be used for the active portion 9K, for example, a p-type AlGaN layer can be used for the electron blocking 9E, for example, a p-type GaN layer can be used for the second light guide 9D, for example, a p-type AlGaN layer can be used for the second cladding 9F, and, for example, a p-type GaN layer can be used for the second contact 9G.

A regrowth portion (e.g., a buffer layer including an n-type GaN-based semiconductor) may be formed on the first semiconductor S1, and the second semiconductor S2 may be formed on the regrowth portion. The n-type semiconductor 9N may be formed by the regrowth portion, and the active portion 9K and the p-type semiconductor 9P in the second semiconductor S2 may be formed on the regrowth portion. The regrowth portion can be formed by the MOCVD method, for example. The first semiconductor S1 and the second semiconductor S2 may be formed by continuously growing without forming the regrowth portion. In other words, the first semiconductor S1 may be grown in the film forming device, and the second semiconductor S2 may be grown subsequently.

### Laminate Body

In the laser element manufacturing method of Example 1, next, a ridge stripe structure, that is, the ridge RJ is formed using a photolithography method, and then the insulation film DF is formed. The first electrode E1 is formed on the second contact 9G of the ridge RJ. In Example 1, a part of the second semiconductor S2 may be etched, for example, to expose a part of the upper surface of the first semiconductor S1, and the second electrode E2 may be formed on the upper surface of the first semiconductor S1 (see FIGs. 4 and 6). This can form the semiconductor substrate 10 having the plurality of laminate bodies LB having a bar shape. Note that the second semiconductor S2 may be etched until, for example, the first contact 9A in the second semiconductor S2 is exposed to form the second electrode E2 on the first contact 9A. That is, the first electrode E1 or the first electrode E1 and the second electrode E2 may be formed on the second semiconductor S2.

For the first electrode E1 (anode) and the second electrode E2 (cathode), for example, a single-layer film or a multilayer film selected from (i) a metal film (that may be an alloy film) containing at least one selected from the group consisting of Ni, Rh, Pd, Cr, Au, W, Pt, Ti, and Al, and (ii) a conductive oxide film containing at least one selected from the group consisting of Zn, In, and Sn can be used. As the insulation film DF covering the ridge RJ, a single-layer film or a laminated film containing an oxide or nitride of, for example, Si, Al, Zr, Ti, Nb, or Ta can be used.

The first electrode E1 may include a p-contact electrode and a p-pad electrode, and the second electrode E2 may include an n-contact electrode and an n-pad electrode. The p-contact electrode may be a Pd film having a thickness of 50 nm, for example. Each of the p-pad electrode and the n-pad electrode may be a multilayer film in which, for example, a Ti film having a thickness of 100 nm, a Ni film having a thickness of 200 nm, and an Au film having a thickness of 100 nm are formed in this order. For example, a Ti film having a thickness of 100 nm in the n-pad electrode may also serve as the n-contact electrode.

For these electrodes, an electrode material is selected to have appropriate adhesion (adhesive force) with a layer in direct contact, and a heat treatment process or the like may be appropriately performed. This will be described later together with the description of selective transfer of the laser body 21 to the support substrate SK.

By providing the ridge RJ and the insulation film DF, the current path between the first electrode E1 and the first semiconductor S1 is constricted on the anode side, and laser light can be efficiently emitted in the resonator LK.

The ridge RJ may overlap the low defect portion SD (corresponding to the second portion B2) of the first semiconductor S1 and needs not overlap the dislocation inheritor HD (corresponding to the first portion B 1) in plan view. The second electrode E2 may overlap the low defect portion SD of the first semiconductor S 1 in plan view. The current path from the first electrode E1 to the second electrode E2 through the second semiconductor S2 and the first semiconductor S1 is formed in a part overlapping the low defect portion SD in plan view (a part having less threading dislocation), whereby the light emission efficiency in the active portion 9K is enhanced. This is because the threading dislocation acts as a non-light-emission recombination center.

### Laser Body

In the laser element manufacturing method of Example 1, next, cleavage of the laminate body LB is performed on the template substrate 7 (m-plane cleavage of the first and second semiconductors S1 and S2, which are nitride semiconductor layers) to form the laser body 21 having the pair of resonator end surfaces F1 and F2. When the laminate body LB has a bar shape, the laminate body LB is cleaved in a direction (X direction) orthogonal to the longitudinal direction (Y direction) of the laminate body LB. The end surface generated by the cleavage can be used as the resonator end surface F, and a plurality of pieces obtained by splitting the laminate body LB can be used as the laser body 21.

In Example 1, scribing (e.g., formation of a scribe groove serving as a cleavage starting point) may be performed on the laminate body LB. A specific method of scribing is not particularly limited, but scribing may be performed on the laminate body LB by applying a force parallel to the m-plane of the nitride semiconductor crystal in the second semiconductor S2 using a scriber for example. The scriber may be a diamond scriber or may be a laser scriber. The cleavage starting point may be formed in the first semiconductor S1 or may be formed in the second semiconductor S2.

In Example 1, the pair of resonator end surfaces F1 and F2 may be formed by cleavage that spontaneously proceeds by scribing the laminate body LB. The first semiconductor S1 includes a GaN-based semiconductor, and the base substrate BK includes the main substrate 1 made of a material having a thermal expansion coefficient smaller than that of the GaN-based semiconductor. For example, the first semiconductor S1 may contain GaN, and the base substrate BK may contain a Si substrate or a SiC substrate.

When the first semiconductor S1 is formed on a dissimilar substrate such as a Si substrate by the ELO method, the film formation temperature is a high temperature of, for example, 1000°C or higher, and the temperature is lowered to room temperature after the film formation, whereby an internal stress is generated in the first semiconductor S1. This internal stress is caused by a difference in thermal expansion coefficient between the main substrate 1 and the first semiconductor S1.

When the thermal expansion coefficient of the main substrate 1 is smaller than the thermal expansion coefficient of the first semiconductor S1, tensile stress is generated in the first semiconductor S1. For example, the main substrate 1 is a Si substrate and the constituent material of the first semiconductor S1 is GaN, and thus tensile stress is generated in the first semiconductor S1. Due to the lattice constant difference between the main substrate 1 and the base semiconductor 8, strain is generated in the first semiconductor S1, and also due to this, internal stress can be generated in the first semiconductor S1. When such the laminate body LB is scribed, the internal stress of the first semiconductor S1 is released and tensile strain occurs at the cleavage starting point, whereby cleavage proceeds spontaneously.

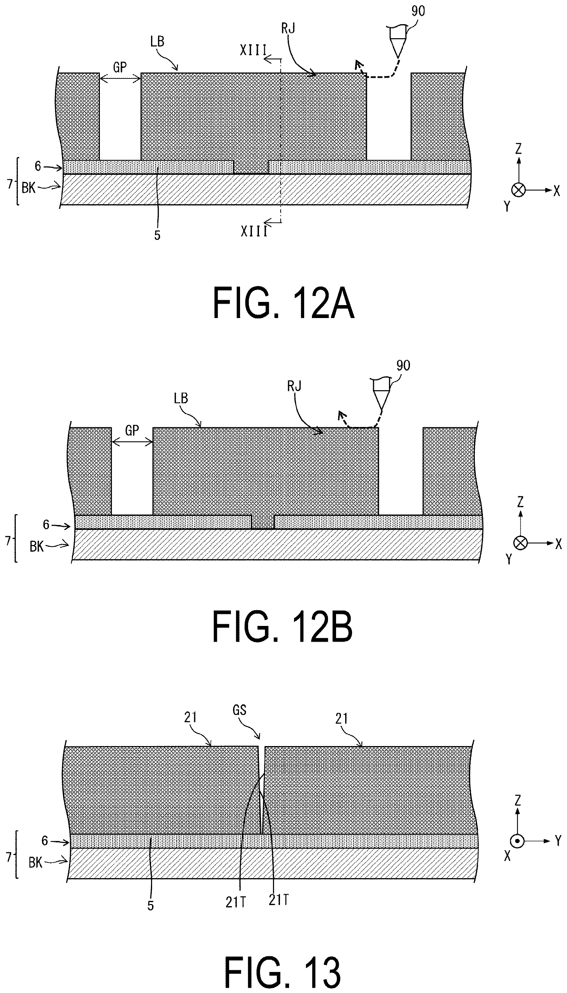

FIGs. 12A and 12B are cross-sectional views illustrating an example of a method of scribing and cleaving the laminate body LB. Since the thickness of the second semiconductor S2 is significantly thinner than that of the first semiconductor S1, FIGs. 12A and 12B illustrate the cross section of the laminate body LB as a simple rectangle (illustration of the ridge RJ is omitted) for the sake of clarity of description. A trajectory of a scribe tool 90 is indicated by a broken line.

As illustrated in FIG. 12A, the presence of the gap GP enables the laminate body LB to be scribed with the tip end of the scribe tool 90 being inserted from the side surface of the laminate body LB and coming out from the upper surface of the laminate body LB. In this case, the scribe tool 90 may pass through the side surface of the second semiconductor S2. When the gap GP is, for example, 5 µm or more, the tip end of the scribe tool 90 can be easily inserted into the side surface of the laminate body LB. As illustrated in FIG. 12B, the laminate body LB may be scribed with the tip end of the scribe tool 90 passing through the upper surface of the laminate body LB, and in this case, the scribe tool 90 may pass through the upper surface of the second semiconductor S2.

The scribe tool 90 may be inserted from the side surface closer to the ridge RJ in the first semiconductor S1. This can reduce the possibility that the quality of the cleavage surface decreases when the cleavage proceeds across the dislocation inheritor HD of the first semiconductor S1, and can easily ensure the quality of the resonator end surface F1 and the resonator end surface F2.

For example, by scribing the laminate body LB at intervals of 100 µm in the longitudinal direction of the laminate body LB, the resonator length L1 of the laser body 21 can be set to 100 µm. By performing scribing, cleavage of the laminate body LB spontaneously proceeds due to internal stress (tensile stress) of the first semiconductor S1, and the laminate body LB can be separated into the plurality of individual laser bodies 21. At this time, the main substrate 1 is not split. The mask portion 5 needs not be split, and may be split due to the influence of cleavage of the laminate body LB. In the part of the opening K of the mask 6, the first semiconductor S1 and the base substrate BK of each laminate body LB are chemically bonded. Therefore, the base semiconductor 8 and the base substrate BK in the laser body 21 are chemically bonded, whereby the laser body 21 is held by the base substrate BK. As a result, the position of the laser body 21 is kept on the base substrate BK.

In general, after the cleavage starting point is formed by scribing, cleavage may be generated from the cleavage starting point by applying stress, but in Example 1, cleavage of the laminate body LB can spontaneously proceed. "Cleavage proceeds spontaneously by scribing" means that scribing and cleavage occur at the same or substantially the same timing (cleavage occurs spontaneously with scribing).

By allowing the cleavage of the laminate body LB to proceed naturally, the step of externally applying stress to the laminate body LB after scribing damage can be omitted. As a result, the possibility that the following phenomenon occurs can be reduced. That is, (i) the possibility that the performance of the laser body 21 is deteriorated due to application of external stress can be reduced, and (ii) the possibility that the laminate body LB is ruptured at a position different from the intended cleavage position (the position where the resonator end surfaces F1 and F2 are formed) can be reduced. The production cost of the laser element 23 can be reduced.

In Example 1, a void (the open groove GS) is formed between the laser bodies 21 adjacent in the Y direction (second direction) by cleaving the laminate body LB including the first semiconductor S1 in which tensile stress is generated to form the resonator end surface F.

FIG. 13 is a cross-sectional view taken along line XIII-XIII illustrated in FIG. 12A as viewed in the direction of arrows. As illustrated in FIG. 13, the open groove GS may be, for example, a gap space having a shape in which the lateral width (size in the Y direction) increases as the distance from the mask portion 5 of the mask 6 increases. For example, the template substrate 7 including the base substrate BK is sometimes warped due to the influence of the internal stress described above, and this justifies the open groove GS as illustrated in FIG. 13. Since the end surface 21T of the laser body 21 is formed by the m-plane cleavage, planarity and perpendicularity to the c-plane (parallelism of the resonator end surfaces F1 and F2) are secured. The open groove GS formed by spontaneously proceeding cleavage can be a gap space larger than a general crack formed by applying external stress after formation of a scribe damage. This can reduced the possibility that the opposing end surfaces 21T of the adjacent laser bodies 21 come into contact with each other when the laser body 21 is separated from the template substrate 7. Therefore, the possibility of generating scratches on the resonator end surfaces F1 and F2 of the laser body 21 can be reduced. The open groove GS may have any shape as long as the laser body 21 can be separated from the template substrate 7, and may be a gap space having various shapes.

In the open groove GS, for example, on the surface of the mask portion 5 and the vicinity thereof of the adjacent laser body 21, there may be a part where cleavage surfaces of the first semiconductor S1 (the end surfaces 8T of the base semiconductors 8) are not completely separated from each other and are in contact with each other.

In Example 1, by forming the laser body 21 by cleavage, the volume of the laminate body LB to be lost can be reduced as compared with a case where the laser body 21 is formed by dry etching, for example. Therefore, the semiconductor substrate 10 can be efficiently used (as an element).

In Example 1, since the resonator end surfaces F1 and F2 are formed by m-plane cleavage, planarity and perpendicularity to the c-plane (parallelism of the resonator end surfaces F1 and F2) are excellent, and high light reflectance can be obtained by high reflection film coating. Therefore, mirror loss can be reduced even with a short resonator length of 200 µm or less at which mirror loss increases, and stable laser oscillation is possible even with a short resonator length of 200 µm or less at which optical gain decreases. Since the resonator end surfaces F1 and F2 at the position corresponding to a light emission region EA are formed on the second portion B2, which is the low defect portion SD, the planarity of the cleavage surface is excellent, and high light reflectance is achieved.

### Selective Transfer

In the laser element manufacturing method of Example 1, next, some of the plurality of laser bodies 21 are selectively transferred to the support substrate SK from the semiconductor substrate 10 including the plurality of laser bodies 21. For example, some selected from the plurality of laser bodies 21 may be transferred from the template substrate 7 to the support substrate SK over the plurality of laser bodies 21, such as every two or every three laser bodies. In the semiconductor substrate 10, the laser bodies 21 are individually separated by having the gap GP and the open groove GS between the laser bodies 21 on the template substrate 7. Therefore, selective transfer can be easily performed.

A specific configuration of the support substrate SK is not particularly limited as long as some of the plurality of laser bodies 21 can be selectively transferred, and an example will be described below.

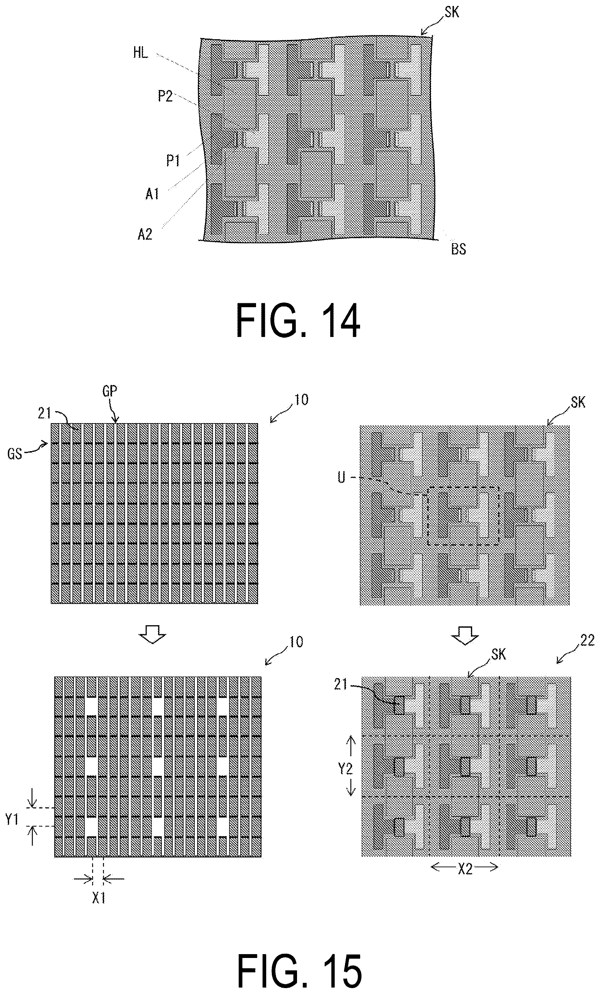

FIG. 14 is a plan view illustrating an example of the configuration of the support substrate SK. As illustrated in FIG. 14, the support substrate SK includes a first pad P1 and a second pad P2 having conductivity and a T shape, the first joint A1 that functions as a joint layer with the first pad P1, and the second joint A2 that functions as a joining layer with the second pad P2. The first joint A1 and the second joint A2 may be solder, for example. The support substrate SK may be formed by providing a plurality of recessed portions HL in a matrix on a substrate body BS and providing a non-recessed portion with the first pad P1, the second pad P2, the first joint A1, and the second joint A2.

In Example 1, after the laser body 21 is formed, the mask portion 5 may be removed by etching using hydrofluoric acid, buffered hydrofluoric acid (BHF), or the like (see FIGs. 8 and 9). That is, the mask portion 5 of the semiconductor substrate 10 may be removed before selective transfer to the support substrate SK. This can easily separate the laser body 21 from the template substrate 7. Since the semiconductor substrate 10 has the gap GP, the mask portion 5 is partially exposed. Therefore, the mask portion 5 is easily etched.

The semiconductor substrate 10 may be split into appropriate sizes by dicing or the like, and for example, may be divided into small pieces of 10 mm square size. The support substrate SK may be split into appropriate sizes by dicing or the like, and for example, the support substrate SK may be split into small pieces of 10 mm square size, which is the same size as the semiconductor substrate 10 having been split into small pieces.

FIG. 15 is a view for explaining a scene of an example of selective transfer, and is a plan view illustrating the semiconductor substrate 10 and the support substrate SK. As illustrated in FIG. 15, some of the plurality of laser bodies 21 on the semiconductor substrate 10 are selectively transferred to the support substrate SK. A known device (e.g., a flip chip bonder) may be used for selective transfer, illustration and detailed description of the device are omitted, and in Example 1, selective transfer can be performed as follows, for example. That is, first, the support substrate SK is placed on a heat stage, and the semiconductor substrate 10 is held by a holding tool. The holding tool is capable of adsorbing a workpiece and, for example, adsorbs and holds the back surface of the semiconductor substrate 10 (e.g., the back surface of the base substrate BK). Using an alignment mark, alignment is performed to put the semiconductor substrate 10 and the support substrate SK in a desired arrangement. In the support substrate SK, a plurality of units U are arranged in a matrix, and each unit U includes the first pad P1, the second pad P2, the first joint A1, and the second joint A2.

An arrangement pitch of the units U on the support substrate SK may be larger than the arrangement pitch of the laser bodies 21 on the semiconductor substrate 10, and the ratio between the arrangement pitch of the units U and the arrangement pitch of the laser bodies 21 may be an integral multiple.

For example, in the semiconductor substrate 10, an arrangement pitch X1 in the first direction (X direction) of the laser body 21 may be 55 µm, and an arrangement pitch Y1 in the second direction (Y direction) may be 100 µm. The arrangement pitch X1 corresponds to the interval between the plurality of openings K arranged in the X direction of the mask 6 in the template substrate 7 in plan view. The arrangement pitch Y1 corresponds to the interval between centers of the adjacent laser bodies 21 in plan view in the plurality of laser bodies 21 arranged in the Y direction formed by cleavage.

For example, in the support substrate SK, an arrangement pitch X2 in the first direction (X direction) of the units U may be 330 m, and an arrangement pitch Y2 in the second direction (Y direction) may be 300 µm.

As described above, by designing the arrangement pitch of the laser bodies 21 on the semiconductor substrate 10 and the arrangement pitch of the units U on the support substrate SK, the plurality of laser bodies 21 can be easily selectively transferred to the support substrate SK.

The aligned semiconductor substrate 10 and the support substrate SK are brought close to each other. The support substrate SK is heated by heating the heat stage. Thus, the first joint A1 and the second joint A2 are melted. The semiconductor substrate 10 may be heated by heating the holding tool.

The semiconductor substrate 10 and the support substrate SK are brought into contact with each other to apply a load. The first joint A1 and the second joint A2 are melted, held for a certain period of time, and then cooled to room temperature. This brings the semiconductor substrate 10 and the support substrate SK into a state of being joined to each other. Specifically, the first electrode E1 and the first pad P1 in the laser body 21 are joined by the first joint A1. The second electrode E2 and the second pad P2 in the laser body 21 are joined by the second joint A2 (see FIGs. 8 and 9).

By applying an external force to move the semiconductor substrate 10 and the support substrate SK away from each other, a desired laser body 21 among the plurality of laser bodies 21 on the semiconductor substrate 10 is selectively transferred to the support substrate SK.

Here, a part of the laser body 21 protruding downward on the back surface of the base semiconductor 8 and positioned in the opening K of the mask 6 is called a joint (coupler) 8S (see FIGs. 8 and 9). The joint 8S and the base substrate BK are chemically bonded to each other. Of the force required for peeling the joint 8S from the base substrate BK and the force required for rupturing the joint 8S, the smaller force is called a first joining force AF1. Of the adhesive force between the first electrode E1 and the first pad P1 by the first joint A1 and the adhesive force between the second electrode E2 and the second pad P2 by the second joint A2, the smaller force is called a second joining force AF2.

The second joining force AF2 larger than the first joining force AF1 can be generated between the semiconductor substrate 10 and the support substrate SK. The second joining force AF2 can be generated by various methods such as eutectic bonding using solder, or an adhesive having electrostatic force or adhesive force.

Since the second joining force AF2 is larger than the first joining force AF1, the joint 8S between the base semiconductor 8 and the base substrate BK is ruptured at the time of selective transfer to the support substrate SK. The joint 8S is peeled off from the base substrate BK. Due to this, the laser body 21 is separated from the template substrate 7 while being joined to the support substrate SK. The laser body 21 separated from the template substrate 7 may have a protrusion 8S1 (see FIGs. 8 and 9) on the back surface of the base semiconductor 8. The protrusion 8S1 includes a part of the joint 8S. The protrusion 8S1 may be removed by polishing or the like.

Of the joining force between the p-pad electrode and the p-contact electrode, and the insulation film DF in a part of the first electrode E1 of the laser body 21 and the joining force between the n-pad electrode and the n-contact electrode in a part of the second electrode E2, the smaller one is called a third joining force AF3. Since the third joining force AF3 is larger than the first joining force AF1, selective transfer can be easily performed appropriately. The third joining force AF3 can be improved, for example, by using an appropriate electrode material and performing a heat treatment process on the first electrode E1 and the second electrode E2.

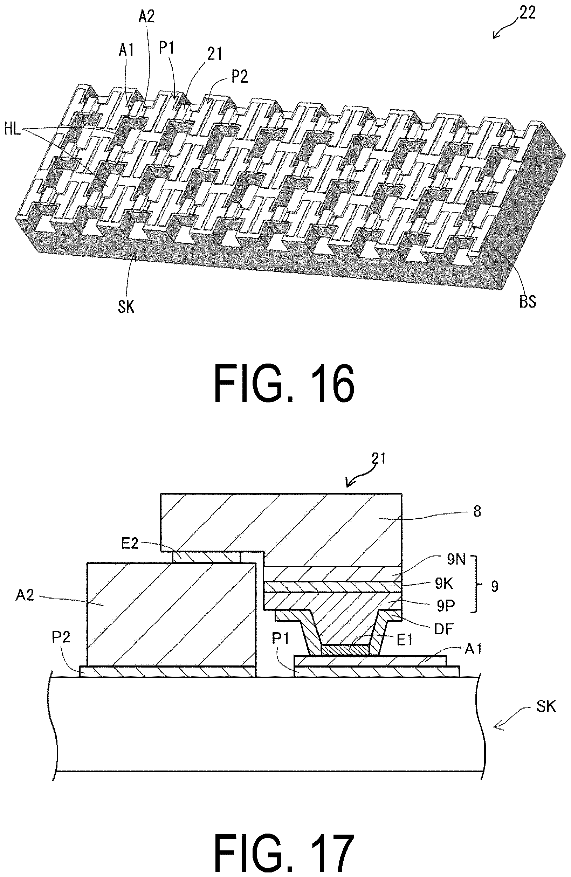

FIG. 16 is a perspective view schematically illustrating the laser substrate 22 with the plurality of laser bodies 21 joined to the support substrate SK. FIG. 17 is a cross-sectional view schematically illustrating the laser body 21 joined to the support substrate SK.

As illustrated in FIGs. 16 and 17, the laser substrate 22 of a two-dimensional arrangement type is formed by selective transfer. In the laser substrate 22, for example, the first electrode E1 may be connected to the first pad P1 via the first joint A1, and the second electrode E2 may be connected to the second pad P2 via the second joint A2. The thickness of the second joint A2 is larger than the thickness of the first joint A1, and the difference between the thickness of the first joint A1 and the thickness of the second joint A2 is equal to or larger than the thickness of the second semiconductor S2. This enables the first and second electrodes E1 and E2 to be connected to the first and second pads P1 and P2 positioned on the same plane.

In Example 1, for example, the support substrate SK may be formed as follows. That is, a 4-inch Si substrate is used as the substrate body BS, and the first pad P1 and the second pad P2 are formed by a wafer process using a photolithography technique. The plurality of recessed portions HL (rectangular in plan view) can be provided in a matrix form with a depth of 100 µm by reactive ion etching (RIE) or the like. The first joint A1 and the second joint A2 are formed. Each of the first pad P1 and the second pad P2 may be a multilayer film in which a Cr film having a thickness of 10 nm, a Pt film having a thickness of 25 nm, and an Au film having a thickness of 100 nm are formed in this order from the substrate body BS side. Each of the first joint A1 and the second joint A2 may be an AuSn joint layer in which an AuSn film having a thickness of 3000 nm and an Au film having a thickness of 100 nm are formed in this order from the substrate body BS side. Solder other than AuSn can be used for the first joint A1 and the second joint A2. The second joining force AF2 can also be generated by metal-metal joint such as Au-Au joint.

The material of the substrate body BS in the support substrate SK and the material of the base substrate BK in the semiconductor substrate 10 may be homogeneous, and may be Si, for example. In this case, the thermal expansion coefficient of the support substrate SK can be made equal to the thermal expansion coefficient of the semiconductor substrate 10. This can improve the accuracy of alignment between the support substrate SK and the semiconductor substrate 10, and reduce the possibility of occurrence of a defect in transfer due to the influence of temperature change by heating and cooling when selective transfer is performed.

Formation of Reflector Film and Split of Laser Substrate The reflector film UF is formed on the resonator end surfaces F1 and F2 of the laser body 21 (see FIGs. 8 and 9). The reflector film UF is formed for reflectance adjustment, passivation, and the like. The reflector film UF may be formed using the laser substrate 22 of a two-dimensional arrangement type, or the reflector film UF may be formed using the laser substrate 22 having a bar shape formed after the laser substrate 22 is divided into a bar shape.

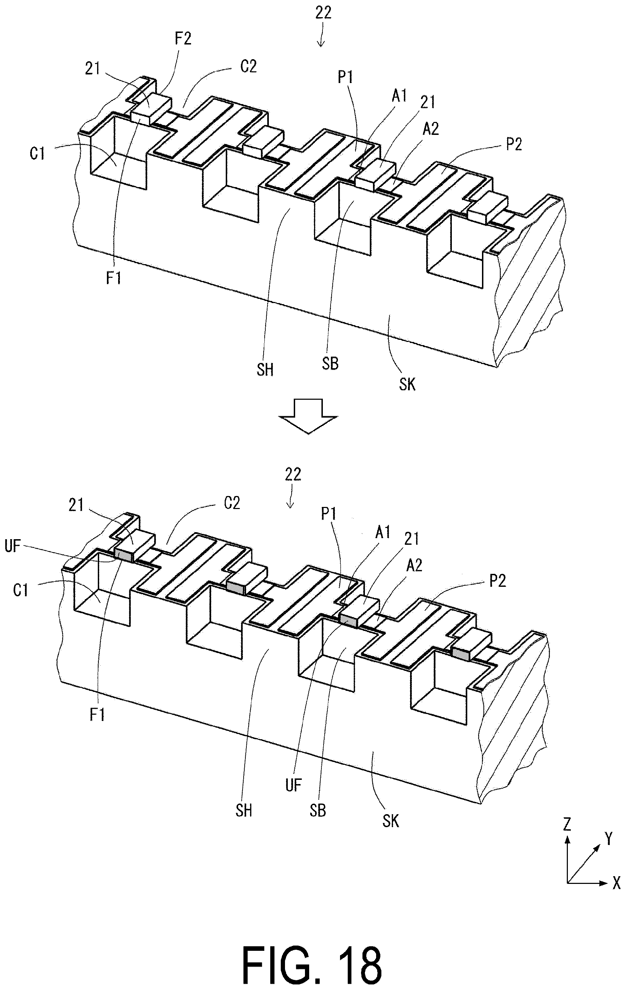

FIG. 18 is a perspective view illustrating an example of the laser substrate 22 having a bar shape after division. The laser substrate 22 of a two-dimensional arrangement type as in FIG. 16 can be laterally divided (split for each row extending in the X direction) to obtain the laser substrate 22 of a one-dimensional arrangement type (bar shape) as in FIG. 18. Thus, after the laser body 21 is selectively transferred to the support substrate SK, the support substrate SK may be divided into multiple pieces. The one-dimensional arrangement type facilitates formation of the reflector film UF on the pair of resonator end surfaces F1 and F2. FIG. 18 illustrates XYZ axes related to the support substrate SK, and the XYZ axes illustrated in FIG. 18 are reversed on the Z-axis positive direction side with respect to the XYZ axes illustrated in FIG. 2 and the like.

The support substrate SK includes a wide portion SH and a placement portion SB. The laser body 21 is positioned above the placement portion SB with the width direction (Y direction) of the placement portion SB coinciding with the direction of the resonator length. In the laser substrate 22, the pair of resonator end surfaces F1 and F2 of the laser body 21 may protrude from the placement portion SB in plan view. The placement portion SB is formed between two cutouts C1 and C2 facing each other in the direction (Y direction) defining the resonator length, the resonator end surface F1 is positioned on the cutout C1, and the resonator end surface F2 is positioned on the cutout C2. The cutouts C1 and C2 are parts corresponding to the recessed portions HL in the support substrate SK before being divided. The shapes of the cutouts C1 and C2 can be, for example, rectangular in plan view viewed in the Z direction. Since the support body ST is provided with the cutouts C1 and C2, the reflector film UF is easily formed on the pair of resonator end surfaces F1 and F2.

Thereafter, the laser substrate 22 may be further divided. Due to this, a plurality of laser elements 23 mounted with one or more laser bodies 21 in a junction-down form (mounting form in which the ridge RJ is positioned on the support body ST side) are formed. The junction-down type can also be said to be a structure in which the active portion 9K is positioned on a side closer to the support substrate SK than the midpoint of the total thickness of the first semiconductor S1 and the second semiconductor S2 in the thickness direction of the laser body 21.

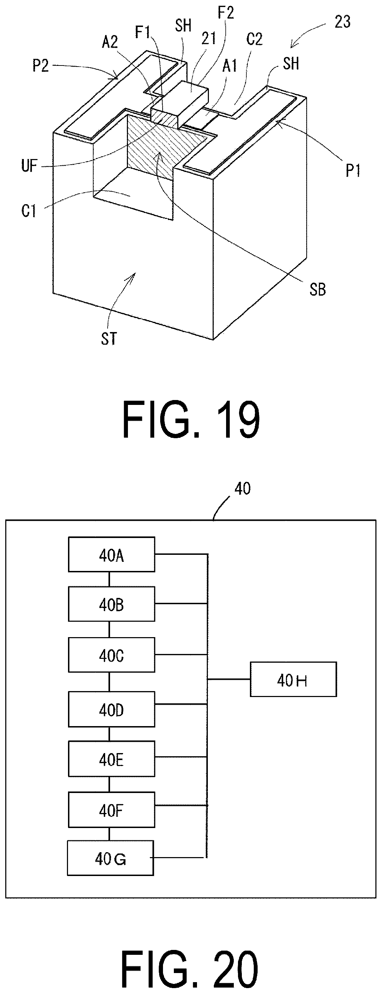

FIG. 19 is a perspective view illustrating the configuration of the laser element 23 in Example 1. As illustrated in FIG. 19, the laser element 23 includes the laser body 21 and the support body ST. The laser element 23 functions as a chip on submount (COS). The reflector film UF may be formed also on the side surface of the placement portion SB.

The laser element 23 has a size larger than that of the laser body 21 corresponding to at least the unit U. The laser element 23 may have the size of the arrangement pitch X2 and the arrangement pitch Y2 described above in plan view.

As described above, according to the laser element manufacturing method in Example 1, the laser element 23 can be formed by transferring from the semiconductor substrate 10 to the support substrate SK and dividing the laser substrate 22. This eliminates the need for the mounting step of individually handling the chip using a collet and mounting the chip on the submount, and thus can improve the productivity of the laser element 23.

In Example 1, the laser element 23 can be mounted with the laser body 21 having a short resonator length of about 100 µm. The laser substrate 22 or the laser element 23 can be handled without directly handling such the small laser body 21. Therefore, handleability is improved. The laser element 23 of high-efficiency and low-output in which power of, for example, 200 [mW] or less is supplied between the first and second electrodes E1 and E2 can be achieved. The laser element 23 can be handled same as and/or similarly to a known COS, and can be packaged.

### Other Configurations

After the selective transfer to the support substrate SK, the plurality of laser bodies 21 remain on the base substrate BK (on the template substrate 7) in the semiconductor substrate 10 (see FIG. 15). After the selective transfer to the support substrate SK, some of the plurality of laser bodies 21 remaining on the semiconductor substrate 10 can be selectively transferred to another support substrate (second substrate) SK.

In Example 1, a sum T1 of the thickness of the base semiconductor 8 (the thickness of the first semiconductor S1, which is the base of the base semiconductor 8) and the thickness of the compound semiconductor 9 (the thickness of the second semiconductor S2, which is the base of the compound semiconductor 9) can be 50 [µm] or less (see FIG. 6). When the sum T1 of these thicknesses is too large, cleavage to a resonator length of 200 µm or less can be difficult. The ratio of the resonator length L1 to the thickness of the second portion B2 of the base semiconductor 8 can be set to 1 to 20. A direction orthogonal to the direction of the resonator length L1 can be the first direction (X direction), the size in the X direction of the second portion B2 can be a width W2 of the second portion B2, and the ratio of the resonator length L1 to the width W2 of the second portion B2 can be 1 to 10. The size in the X direction of the first portion B 1 can be a width W1 of the first portion B 1, and the ratio of the resonator length L1 to the width W1 of the first portion B 1 can be 1 to 200.

The first electrode E1 and the second electrode E2 may be formed avoiding a part where the open groove GS is formed, that is, a position where scribing is performed. The length in the Y direction of the first electrode E1 and the length in the Y direction of the second electrode E2 may each be smaller than the resonator length L1.

The base semiconductor 8 may include the end surface 8T (cleavage surface, see FIG. 4) that is flush with the resonator end surface F1, and the density of dislocation (dislocation, mainly basal plane dislocation, subjected to CL measurement in cleavage surface) on the end surface 8T may be equal to or greater than the threading dislocation density of the second portion B2. The surface roughness of the pair of resonator end surfaces F1 and/or F2 (e.g., the resonator end surface F2 on the reflection surface side) can be made smaller than the surface roughness of a side surface 9S (see FIG. 4), which is the a-plane of the compound semiconductor 9.

The first semiconductor S1 may include a GaN-based semiconductor, and the mask 6 in the template substrate 7 may have a plurality of inorganic films having a strip shape functioning as the mask portion 5 arranged in the <11-20> direction in the GaN-based semiconductor crystal of each first semiconductor S1 with a gap functioning as the opening K.

### Manufacturing Device

FIG. 20 is a block diagram illustrating the laser element manufacturing device in Example 1. As illustrated in FIG. 20, the laser element manufacturing method of Example 1 can be achieved by a manufacturing device 40 for a laser element that executes each step. The manufacturing device 40 for a laser element of Example 1 may include a device 40A configured to prepare the template substrate 7, a device 40B configured to form the first semiconductor S1, a device 40C configured to form the second semiconductor S2 having the ridge RJ, a device 40D configured to form the first electrode E1 and the second electrode E2, a device 40E configured to cleave the laminate body LB, a device 40F configured to selectively transfer the laser body 21 to the support substrate SK, a device 40G configured to form the reflector film UF on the pair of resonator end surfaces F, and a device 40H configured to control the devices 40A to 40G. For example, an MOCVD device can be used for the devices 40B and 40C. The device 40B may be used as the device 40C. For example, a sputtering device can be used for the device 40D. The device 40E may include a photolithography device. The device 40H may include a processor and a memory. The device 40H may be configured to control at least one selected from the group consisting of the devices 40A to 40G by executing a program stored in, for example, a built-in memory, a communicable external device, or an accessible network, and Example 1 also includes this program, and a recording medium and an external device storing this program.

When the template substrate 7 prepared in advance is used, the manufacturing device 40 needs not include the device 40A. When the semiconductor substrate 10 in which the first semiconductor S1 is formed on the template substrate 7 in advance is used, the manufacturing device 40 needs not include the device 40A and the device 40B. When the semiconductor substrate 10 in which the first semiconductor S1 and the second semiconductor S2 are formed on the template substrate 7 in advance is used, the manufacturing device 40 needs not include the device 40A, the device 40B, and the device 40C. When the semiconductor substrate 10 in which the laminate body LB is formed on the template substrate 7 in advance is used, the manufacturing device 40 needs not include the device 40A, the device 40B, the device 40C, and the device 40D.

### Another Configuration Example 1

### 1A

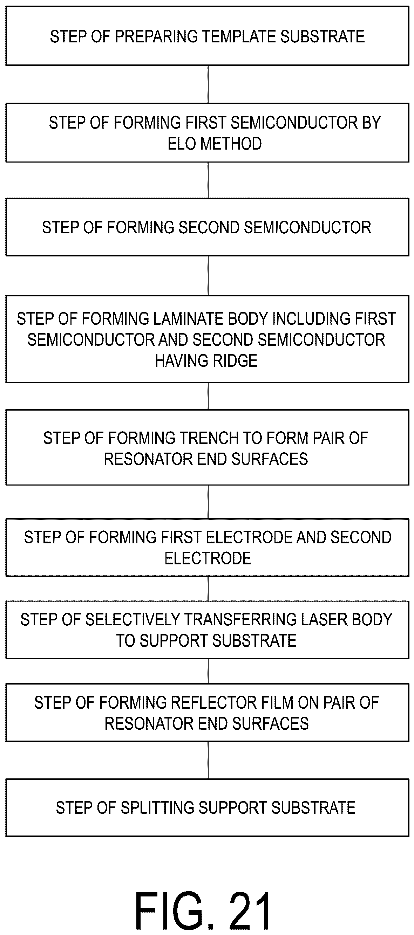

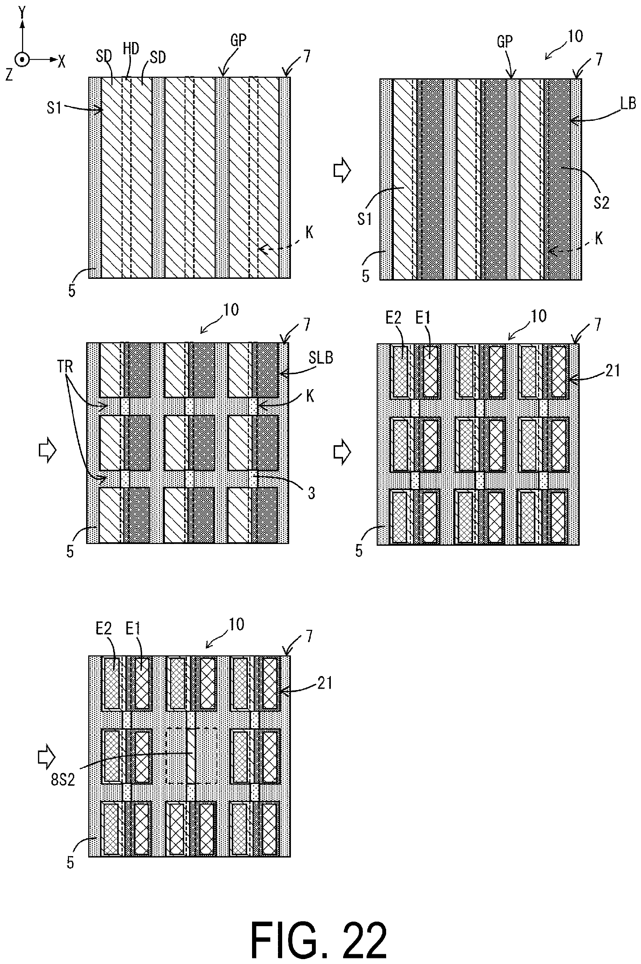

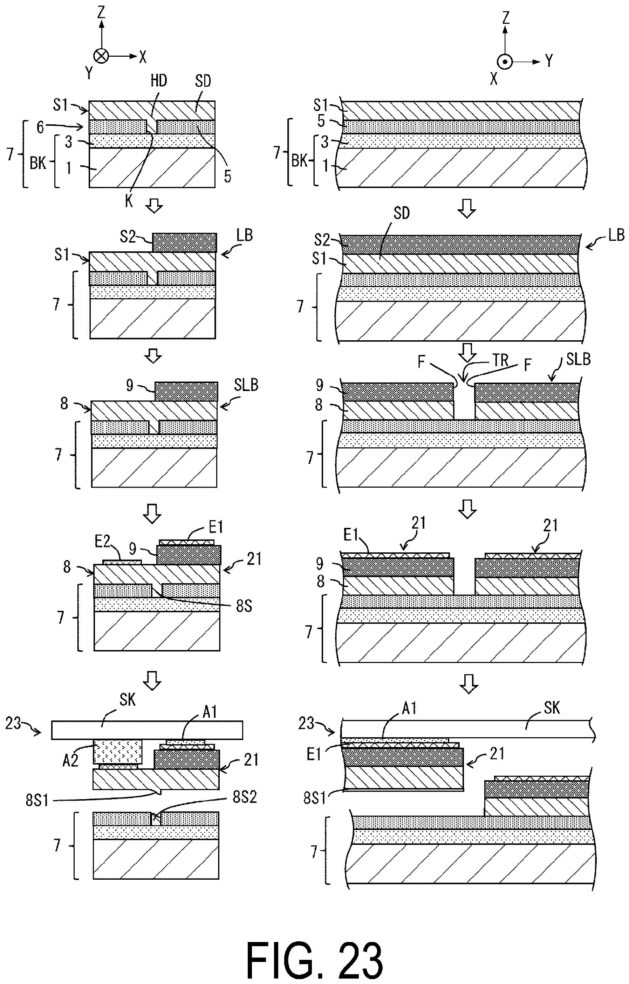

FIG. 21 is a flowchart schematically illustrating another example of the laser element manufacturing method in Example 1. FIG. 22 is a plan view schematically illustrating another example of the laser element manufacturing method in Example 1. FIG. 23 is a cross-sectional view schematically illustrating another example of the laser element manufacturing method in Example 1. In FIG. 22, identical members are hatched identically in the plan view for the sake of clarity of illustration. This also applies to other plan views referred to for the description of the laser element manufacturing method in the following description, and repeated description is omitted.

In Example 1, the resonator end surface F is formed by cleaving the laminate body LB. As another example of Example 1, another configuration example 1A in which the resonator end surface F is formed by forming a plurality of trenches in the laminate body LB will be described below.

As illustrated in FIGs. 21 to 23, the first semiconductor S1 is formed above the prepared template substrate 7 by the ELO method, and then the second semiconductor S2 is formed above the first semiconductor S1. The plurality of laminate bodies LB having a bar shape including the first semiconductor S1 and the second semiconductor S2 having the ridge RJ (not illustrated) are formed. In the laminate body LB, the first semiconductor S1 may be partially exposed by, for example, removing some of the second semiconductors S2. In this way, the semiconductor substrate 10 having the laminate body LB is prepared.

A plurality of trenches TR (open grooves GS) can be formed in the laminate body LB by etching. Due to this, the laminate body LB is split into a plurality of small laminate bodies SLB. In the configuration example 1A, the pair of resonator end surfaces F (etched mirrors) can be formed by performing dry etching on the laminate body LB.

At least one of the plurality of trenches TR may extend in the width direction (X direction) of the opening K. The small laminate body SLB may be formed in an island shape (not connected to the surroundings) by the plurality of trenches TR and the gap GP. The etching with respect to the laminate body LB is dry etching, and this dry etching may be stopped by the mask portion 5. In this case, the mask portion 5 functions as an etching stopper, and the mask portion 5 is exposed at the bottom of the trench TR. In this case, the etching does not necessarily need to stop at the surface of the mask portion 5 and may stop in the mask portion 5. The mask portion 5 may be partially etched as long as the mask portion 5 is made of a material that is less likely to be etched than the first semiconductor S1 and plays a role to stop etching.

When the trench TR is formed to extend in the width direction (X direction) of the opening K, warpage of the wafer can be reduced. This is remarkable when a dissimilar substrate having a thermal expansion coefficient different from that of the first semiconductor S1 is used as the main substrate 1. Note that in the present description, the main substrate 1, the base substrate BK, the template substrate 7, or the semiconductor substrate 10 may be collectively called a wafer. For example, as illustrated in FIG. 22, the first semiconductors S1 adjacent to each other in the X direction are separated by the gap GP. Therefore, warpage of the wafer in the X direction is small. However, since the first semiconductor S1 is formed in the Y direction continuously longer than the size (width) in the X direction, warpage of the wafer in the Y direction can be increased. By dividing the first semiconductor S1 extending in the Y direction by the trench TR in the X direction, internal stress is relaxed, and warpage of the wafer in the Y direction can be reduced. This can improve the accuracy of alignment between the semiconductor substrate 10 and the support substrate SK when selective transfer is performed, for example. This effect similarly occurs also when the open groove GS is provided by cleavage as in Example 1 described above.

The insulation film DF (not illustrated) is formed on the ridge RJ in the small laminate body SLB, and the first electrode E1 is formed on the second contact 9G (not illustrated). The small laminate body SLB includes the base semiconductor 8 positioned above the base substrate BK and the compound semiconductor 9 positioned above the base semiconductor 8. The second electrode E2 is formed on the upper surface of the base semiconductor 8. Thus, the laser body 21 can be formed.

Some of the plurality of laser bodies 21 on the semiconductor substrate 10 are joined to the support substrate SK, and an external force is applied to move the semiconductor substrate 10 and the support substrate SK away from each other, whereby the base semiconductor 8 of the laser body 21 and the mask portion 5 of the template substrate 7 are separated from each other. Due to this, the laser body 21 is selectively transferred to the support substrate SK. The joint 8S of the base semiconductor 8 may be ruptured, and the selectively transferred laser body 21 may have the protrusion 8S1 on the back surface of the base semiconductor 8. The semiconductor substrate 10 may have a peeling trace 8S2, which is a remaining portion of the ruptured joint 8S, in the opening K of the mask 6.

The laser substrate 22 of a two-dimensional arrangement type mounted with the laser bodies 21 in a matrix may be formed, and the laser substrate 22 of a two-dimensional arrangement type may be split to form the laser substrate 22 of a one-dimensional arrangement type (rod shape). The reflector film UF is formed on the resonator end surfaces F1 and F2 of the laser body 21. By splitting the support substrate SK, the laser element 23 including the laser body 21 and the support body ST thereof can be obtained.

### 1B

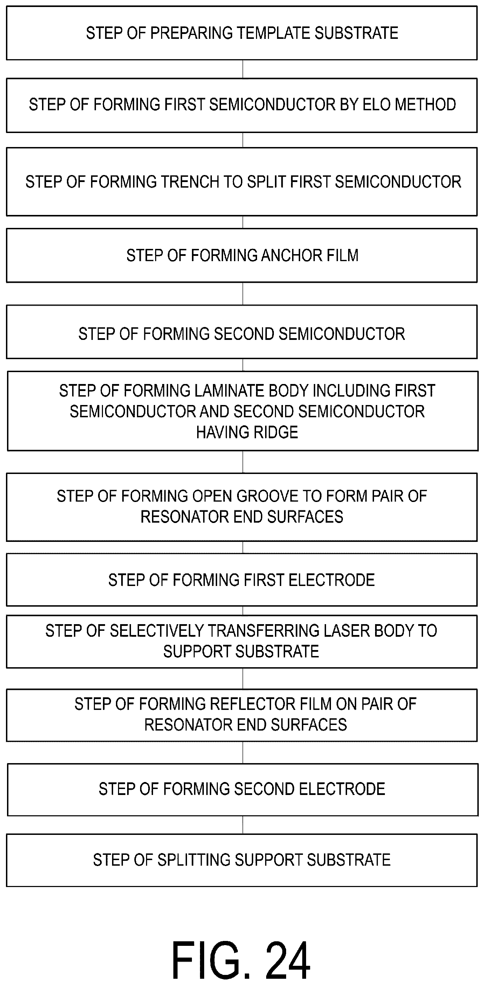

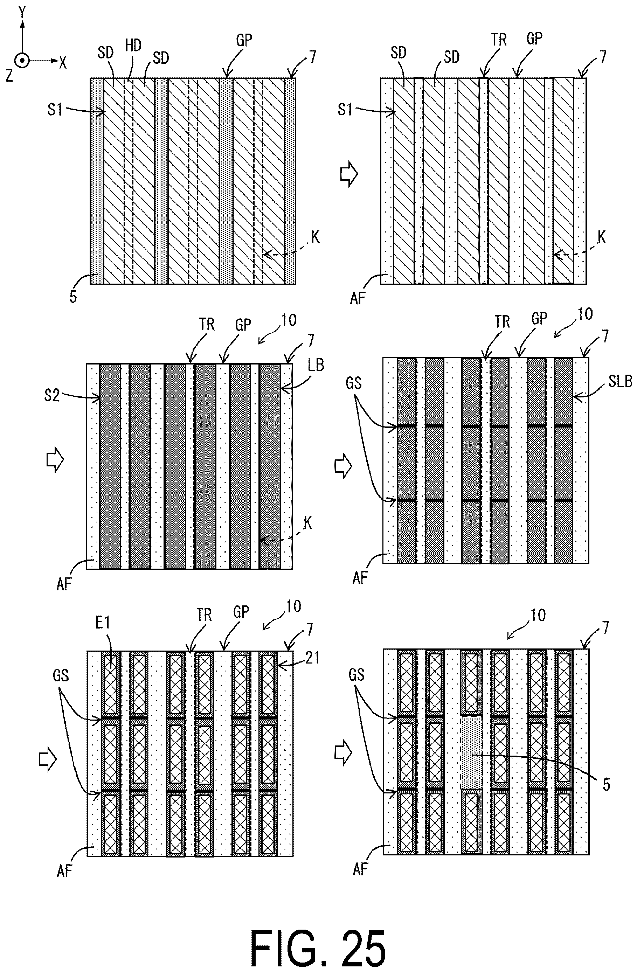

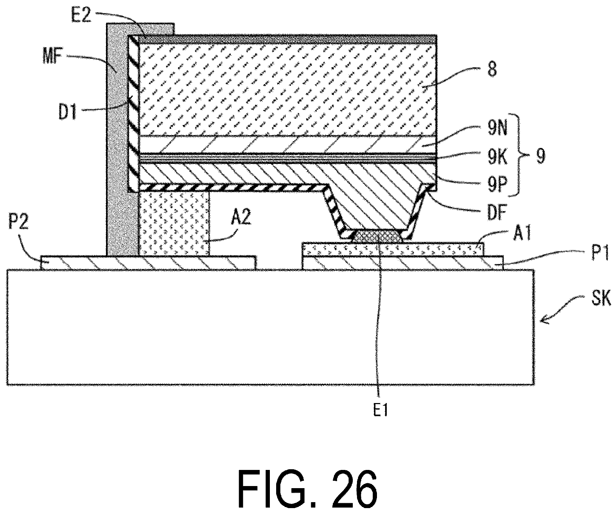

FIG. 24 is a flowchart schematically illustrating another example of the laser element manufacturing method in Example 1. FIG. 25 is a plan view schematically illustrating another example of the laser element manufacturing method in Example 1. FIG. 26 is a cross-sectional view schematically illustrating the laser body 21 joined to the support substrate SK.

In Example 1 and the configuration example 1A, the laminate body LB is formed by forming the second semiconductor S2 on the first semiconductor S1 having the low defect portion SD and the dislocation inheritor HD. The laser body 21 having a single-sided two-electrode structure is formed. As another example thereof, another configuration example 1B in which the part (dislocation inheritor HD) on the opening K in the first semiconductor S1 formed on the template substrate 7 is removed and the second semiconductor S2 is formed on the first semiconductor S1 having the low defect portion SD will be described below. In the configuration example 1B, an example in which the laser body 21 having a double-sided electrode structure is formed will be described, but the laser body 21 may have a single-sided two-electrode structure. The laser body 21 of Example 1 and the configuration example 1A described above can have a double-sided electrode structure as described in the configuration example 1B.

As illustrated in FIGs. 24 and 25, the first semiconductor S1 is formed above the prepared template substrate 7 by the ELO method. Thereafter, the plurality of trenches TR are formed in the first semiconductor S1 by etching to remove a coupler between the first semiconductor S1 and the seed 3 (see FIG. 10 and the like) of the template substrate 7. Thus, the first semiconductor S1 is split.

That is, in the configuration example 1B, growth of the plurality of semiconductor crystals (e.g., GaN-based crystals) growing and coming close to each other on the mask portion 5 is stopped before they are associated with each other, and then the semiconductor crystals in the opening K are removed to form the plurality of first semiconductors S1. The trench TR may extend in the longitudinal direction (Y direction) of the opening K.

In the configuration example 1B, since the first semiconductor S1 is gently coupled to the mask portion 5, to prevent the first semiconductor S1 from being displaced by the template substrate 7, an anchor film AF can be formed after forming the plurality of trenches TR and then the second semiconductor S2 can be formed.

The anchor film AF is in contact with the side surface of the first semiconductor S1 and the mask portion 5, and anchors the first semiconductor S1 to the template substrate 7. As the anchor film AF, a dielectric film and the like such as a silicon oxide film, a silicon nitride film, an aluminum oxide film, a silicon oxynitride film, an aluminum oxide-silicon film, an aluminum oxynitride film, a zirconium oxide film, a titanium oxide film, and a tantalum oxide film can be used. By using a silicon oxide film, a silicon nitride film, an aluminum oxide-silicon film, a silicon oxynitride film, a titanium nitride film, or the like for the anchor film AF, the nitride semiconductor of the second semiconductor S2 does not grow on the anchor film AF, and thus the second semiconductor S2 can be formed in an island shape.

In the selective transfer of the laser body 21 subsequently, at least a part of the anchor film AF may remain on the template substrate 7 or may be attached to the laser body 21.

The laminate body LB including the first semiconductor S1 and the second semiconductor S2 having the ridge RJ is formed. In this way, the semiconductor substrate 10 having the laminate body LB is prepared. The open groove GS is formed in the laminate body LB. Due to this, the laminate body LB is split into a plurality of small laminate bodies SLB. The open groove GS may be a gap space generated by cleavage or may be the trench TR. The open groove GS may be formed after the following step, and may be formed after the laser body 21 is formed by forming the first electrode E1, for example. The trench TR that removes the semiconductor crystal of the opening K and the trench TR as the open groove GS may be formed simultaneously (at once by etching processing, for example). In that case, the anchor film AF may be formed before the formation of the trench TR.

The insulation film DF (not illustrated) is formed on the ridge RJ in the small laminate body SLB, and the first electrode E1 is formed on the second contact 9G (not illustrated). In the configuration example 1B, the second electrode E2 is not formed on the small laminate body SLB on the semiconductor substrate 10, but in the present description, a structure having the first electrode E1 and not having the second electrode E2 is also called the laser body 21.

Some of the plurality of laser bodies 21 on the semiconductor substrate 10 are selectively transferred to the support substrate SK. Although not illustrated, in the laser body 21 mounted on the support substrate SK, the second electrode E2 can be formed on the back surface (the surface on the side far from the support substrate SK) of the base semiconductor 8. The laser body 21 having a double-sided electrode structure may be mounted on the support substrate SK as in FIG. 26, for example. For example, the first electrode E1 may be connected to the first pad P1 via the first joint A1. The insulation film DF and the second pad P2 may be joined to each other via the second joint A2, and in this case, the stability of the laser body 21 being supported by the support substrate SK can be improved.

The insulation film D1 covering the side surfaces of the base semiconductor 8 and the compound semiconductor 9 and a conductive film MF may be formed. The conductive film MF electrically connects the second electrode E2 to the second joint A2 or the second pad P2. The material of the electrically conductive film MF is not particularly limited. The conductive film MF may be in contact with the insulation film D1 and/or the second joint A2.

### Example 2

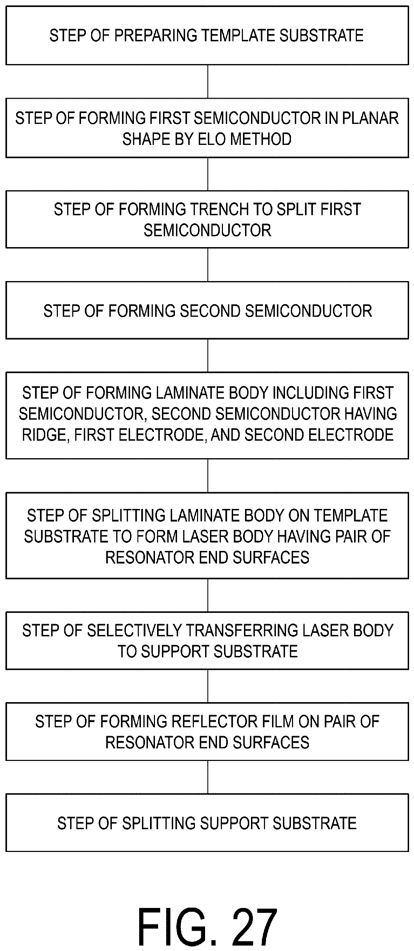

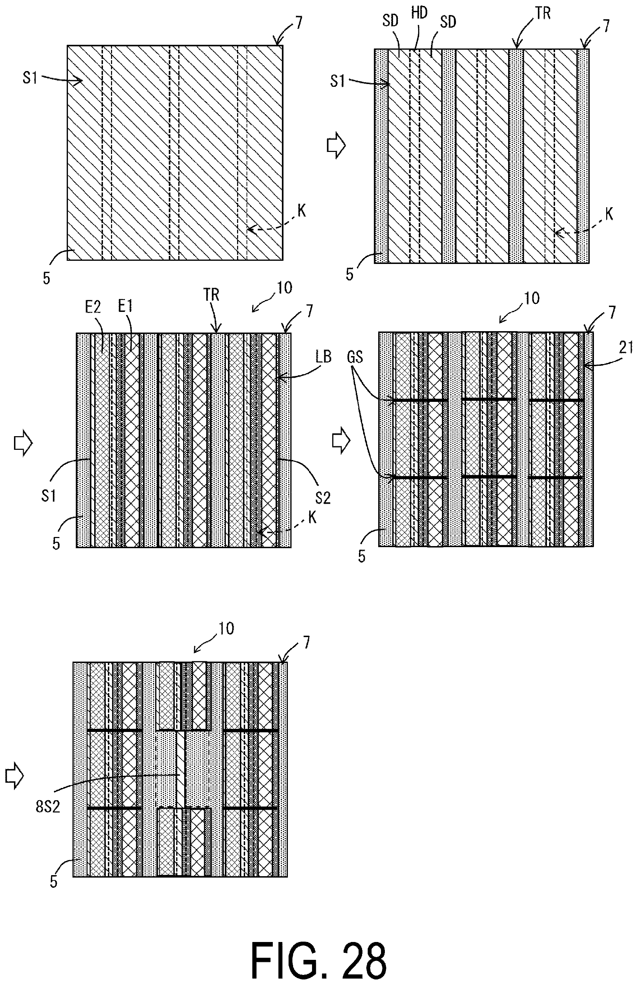

FIG. 27 is a flowchart schematically illustrating the laser element manufacturing method in Example 2. FIG. 28 is a plan view schematically illustrating the laser element manufacturing method in Example 2.

In Example 1, the first semiconductor S1 is formed to have the gap GP. In Example 2, after the first semiconductor S1 is formed in a planar shape using the ELO method, the plurality of first semiconductors S1 having a bar shape are formed by etching or the like.

As illustrated in FIGs. 27 and 28, the first semiconductor S1 is formed above the prepared template substrate 7 by the ELO method. In Example 2, the growth of the semiconductor crystals (e.g., GaN-based crystals) growing and coming close to each other on the mask portion 5 is stopped before they are associated with each other on the mask portion 5. Thereafter, the plurality of first semiconductors S1 are formed by removing the semiconductor crystal of an association portion.

The association occurs substantially at a center of the adjacent openings K (center of the mask portion 5), and a void may be formed directly below the association portion. This void is formed inside the first semiconductor S1 generated by the association and plays a role of releasing strain after the association. By forming the plurality of trenches TR extending in the Y direction with respect to the first semiconductor S1 having a planar shape in plan view, the plurality of first semiconductors S1 having a bar shape are formed. The subsequent steps can be performed in the same and/or similar flow to that of Example 1 and the other configuration examples of Example 1 described above.

For example, the laminate body LB including the first semiconductor S1, the second semiconductor S2 having the ridge RJ, the first electrode E1, and the second electrode E2 is formed. In this way, the semiconductor substrate 10 having the laminate body LB is prepared. The open groove GS is formed in the laminate body LB. Due to this, the laminate body LB is split into the plurality of laser bodies 21. The laser body 21 has the pair of resonator end surfaces F. The open groove GS may be a gap space generated by cleavage or may be the trench TR.

Some of the plurality of laser bodies 21 are selectively transferred to the support substrate SK. The semiconductor substrate 10 may have the peeling trace 8S2 in the opening K of the mask 6.

### Another Configuration Example 2

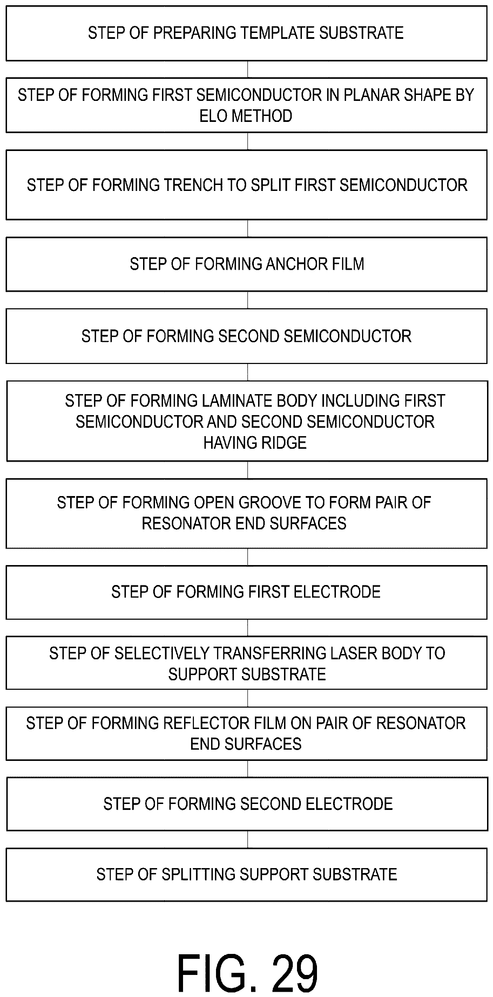

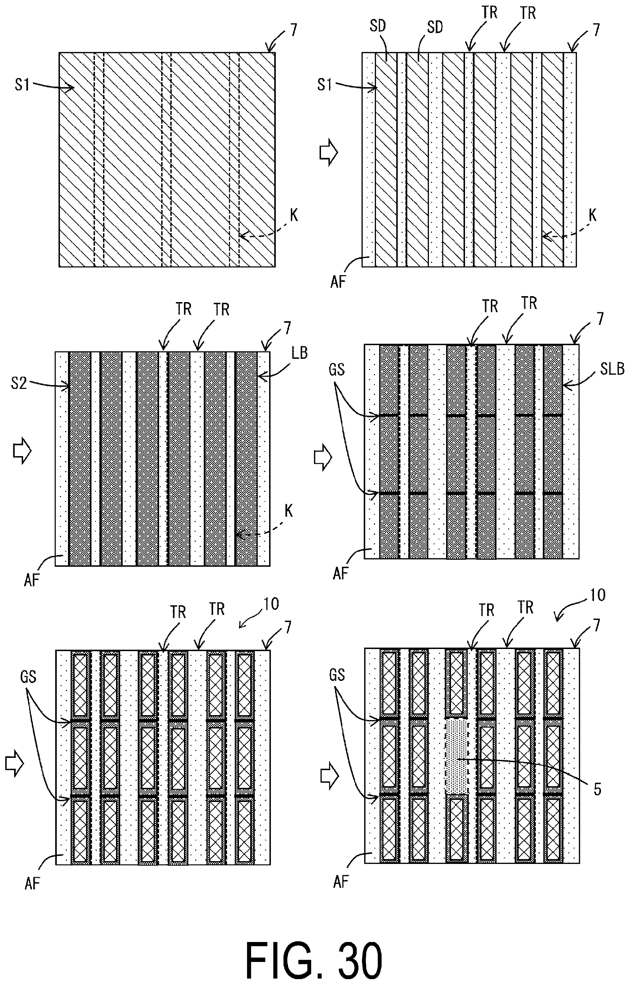

FIG. 29 is a flowchart schematically illustrating another example of the laser element manufacturing method in Example 2. FIG. 30 is a plan view schematically illustrating another example of the laser element manufacturing method in Example 2.

As illustrated in FIGs. 29 and 30, the first semiconductor S1 is formed above the prepared template substrate 7 by the ELO method. In the configuration example 2, the growth is stopped after the semiconductor crystals (e.g., GaN-based crystals) growing and coming close to each other on the mask portion 5 are associated with each other on the mask portion 5. Thereafter, the plurality of first semiconductors S1 are formed by removing the semiconductor crystal of the association portion and the semiconductor crystal of the opening K.

For example, by forming the plurality of trenches TR extending in the Y direction for removing the semiconductor crystal of the association portion and the semiconductor crystal of the opening K with respect to the first semiconductor S1 having a planar shape in plan view, the plurality of first semiconductors S1 having a bar shape are formed. The second semiconductor S2 can be formed on the first semiconductor S1 having the low defect portion SD. The subsequent steps can be performed in the same and/or similar flow to that of the above-described configuration example 1B.

### Example 3

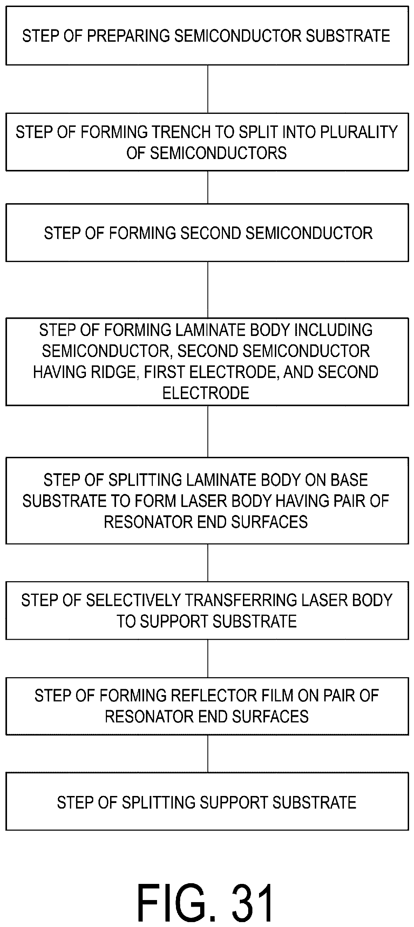

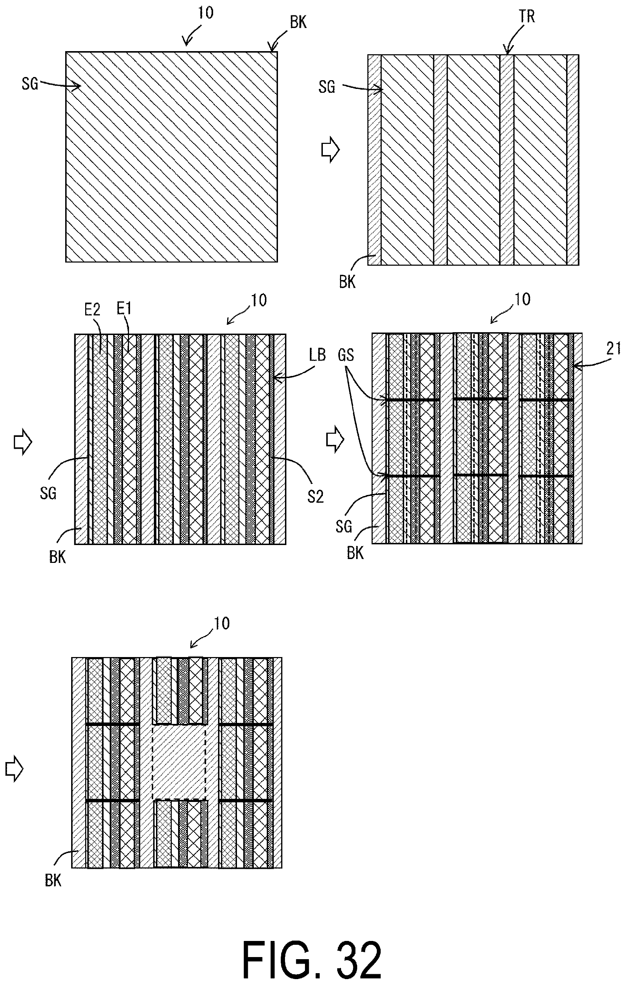

FIG. 31 is a flowchart schematically illustrating the laser element manufacturing method in Example 3. FIG. 32 is a plan view schematically illustrating the laser element manufacturing method in Example 3.

In Examples 1 and 2, the first semiconductor S1 is formed by the ELO method. The present invention is not limited to this, and in the laser element manufacturing method according to one example of the present disclosure, for example, a sapphire substrate may be used as the base substrate BK, and the semiconductor substrate 10 needs not have the mask 6 on the GaN substrate. In the semiconductor substrate 10, a semiconductor layer containing a nitride semiconductor may be formed in a planar shape above the sapphire substrate.

In the present description, a semiconductor formed by a general method is called a semiconductor SG in order to be distinguished from the first semiconductor S1 formed by the ELO method. The semiconductor SG is, for example, a semiconductor layer including a general nitride semiconductor epitaxially grown in the longitudinal direction on the growth substrate.

As illustrated in FIGs. 31 and 32, the plurality of semiconductors SG having a bar shape can be formed by removing, by etching, some of the semiconductors SG in the semiconductor substrate 10, for example. The second semiconductor S2 having the ridge RJ in the semiconductor SG shape is formed, and the first electrode E1 and the second electrode E2 are formed. Subsequent steps can be performed as in Example 1 and the like described above. Peeling of the laser body 21 from the base substrate BK may be performed by various methods, for example, a laser lift-off method, and a frangible layer (boron nitride) for facilitating mechanical peeling may be formed between the base substrate BK and the semiconductor SG. A sacrificial layer (InGaN) that enables lift-off by photoelectrochemical etching may be formed.

### Example 4

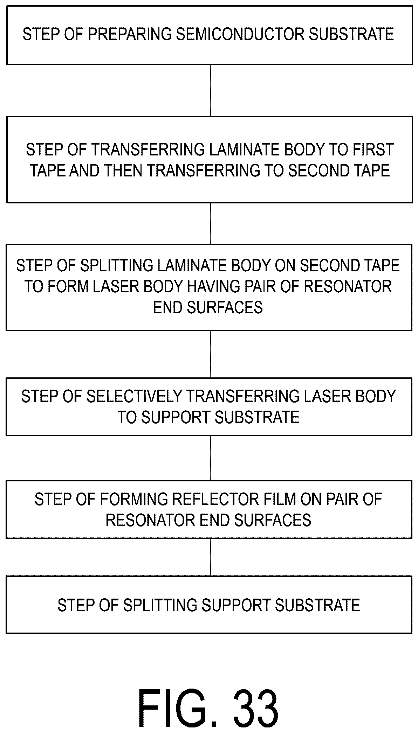

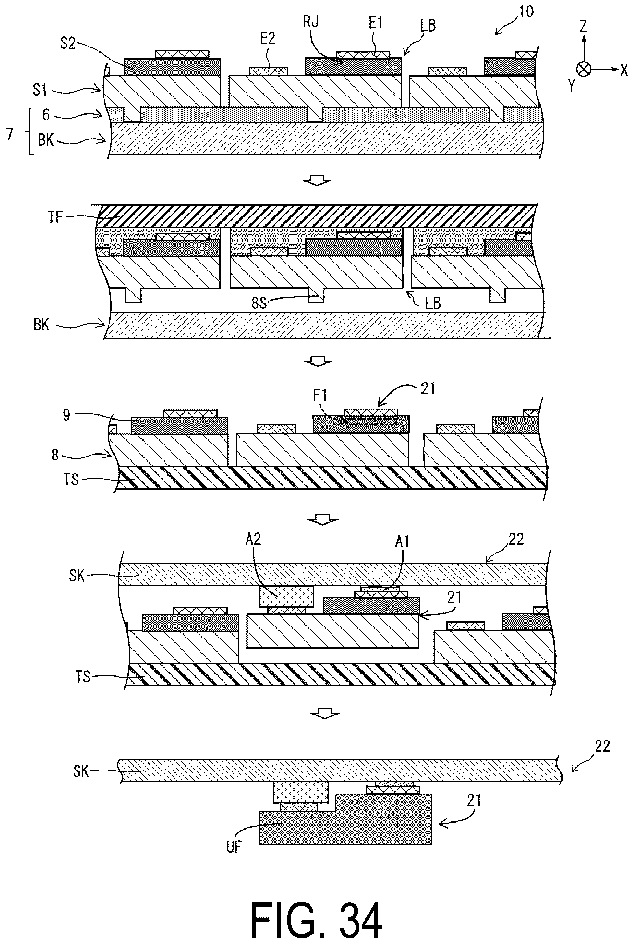

FIG. 33 is a flowchart schematically illustrating the laser element manufacturing method in Example 4. FIG. 34 is a cross-sectional view schematically illustrating the laser element manufacturing method in Example 4. Note that in FIG. 34, among the plurality of drawings illustrated from the top to the bottom along the flow of processing, for convenience of description, the third view from the top and subsequent views illustrate the end surface of the laser body 21.

As presented in FIGs. 33 and 34, the laser element manufacturing method in Example 4 includes forming the semiconductor substrate 10 including the base substrate BK and the plurality of laminate bodies LB having a bar shape arranged side by side in the first direction (X direction) above the base substrate BK, once transferring the plurality of laminate bodies LB having a bar shape to a first tape TF, then transferring the plurality of laminate bodies LB having a bar shape to a second tape TS, and forming the resonator end surface F by splitting each laminate body LB into the plurality of laser bodies 21 arranged side by side in the second direction (Y direction) orthogonal to the first direction without dividing the second tape TS; and selectively transferring, to the support substrate SK, some of the plurality of laser bodies 21 obtained from the plurality of laminate bodies LB.

After formation of the laminate body LB, the mask 6 is removed by etching, and the laminate body LB is transferred to the adhesive first tape TF, whereby the first semiconductor S1 is separated from the template substrate 7. The laminate body LB may have the joint 8S on the back surface of the first semiconductor S1, and the joint 8S may be removed by polishing or the like. In Example 4, the first semiconductor S1 from which the joint 8S has been removed is adhered to the second tape TS, and the laminate body LB is transferred to the second tape TS. The laminate body LB may be transferred to the second tape TS by adhering the first semiconductor S1 having the joint 8S to the second tape TS.

Thereafter, the laminate body LB is split on the second tape TS to form the plurality of laser bodies 21 having the pair of resonator end surfaces F. The split of the laminate body LB may be performed by cleavage or may be performed by etching. Some of the plurality of laser bodies 21 on the second tape TS are joined to the support substrate SK. Thus, the laser substrate 22 of a two-dimensional arrangement type (see FIG. 16) is formed. The laser substrate 22 of a two-dimensional arrangement type is split for each row to form the laser substrate 22 of a one-dimensional arrangement type (rod shape) (see FIG. 18). The reflector film UF is formed on the resonator end surfaces F1 and F2 of the laser substrate 22 of a one-dimensional arrangement type. Thereafter, the support substrate SK is split into the plurality of support bodies ST, and each of the support bodies ST is caused to hold one or more laser bodies 21 to form the plurality of laser elements 23 (see FIG. 19). Each laser body 21 is held by the support body ST in the junction-down form (mounting form in which the ridge RJ is positioned on the support body ST side).

As a base member of the first tape TF, a material such as polyethylene terephthalate (PET) can be used. As a base material of the second tape TS, a material such as polyimide can be used. The base members of the first and second tapes TF and TS may be made of the same material or may be made of different materials.

Some of the plurality of laminate bodies LB in the semiconductor substrate 10 may be selectively transferred to the first tape TF, or some of the plurality of laminate bodies LB held on the first tape TF may be selectively transferred to the second tape TS. In this case, when the laminate body LB is split on the second tape TS, scribing on the laminate body LB can be easily performed.

### Supplementary Notes

In the present disclosure, the invention has been described above based on the various drawings and examples. However, the invention according to the present disclosure is not limited to the above-described embodiments and examples. That is, the invention according to the present disclosure can be variously modified within the scope shown in the present disclosure, and embodiments obtained by appropriately combining the technical means disclosed in different embodiments and examples are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

5 Mask portion
6 Mask
7 Template substrate
10 Semiconductor substrate
21 Laser body
22 Laser substrate
23 Laser element
F, F 1, F2 Resonator end surface
BK Base substrate
K Opening
GS Open groove
LB Laminate body
S1 First semiconductor
S2 Second semiconductor
SK Support substrate (first substrate and second substrate)

## Claims

1. A laser element manufacturing method, comprising the steps of:
preparing a semiconductor substrate comprising a base substrate and a plurality of laminate bodies having a bar shape and arranged side by side in a first direction above the base substrate;
forming a resonator end surface by splitting each laminate body into a plurality of laser bodies arranged in a second direction orthogonal to the first direction, without dividing the base substrate; and
selectively transferring, to a first substrate, some of the plurality of laser bodies obtained from the plurality of laminate bodies.

2. The laser element manufacturing method according to claim 1, wherein the laminate body comprises a first semiconductor positioned above the base substrate and a second semiconductor positioned above the first semiconductor.

3. The laser element manufacturing method according to claim 2, wherein in the step of forming the resonator end surface, a void is formed between the laser bodies adjacent in the second direction.

4. The laser element manufacturing method according to claim 2 or 3, wherein the resonator end surface is formed by cleavage that spontaneously proceeds by scribing each laminate body.

5. The laser element manufacturing method according to claim 2 or 3, wherein the resonator end surface is formed by performing dry etching on each laminate body.

6. The laser element manufacturing method according to any one of claims 2 to 5, wherein
the second semiconductor comprises a nitride semiconductor, and
the resonator end surface is an m-plane of the second semiconductor.

7. The laser element manufacturing method according to claim 4, wherein
the second semiconductor comprises a nitride semiconductor, and
a force parallel to the m-plane of the second semiconductor is applied by a scriber.

8. The laser element manufacturing method according to claim 4, wherein a scribe tool passes through a side surface or an upper surface of the second semiconductor.

9. The laser element manufacturing method according to any one of claims 2 to 8, wherein the first semiconductor and the base substrate of each laminate body are coupled.

10. The laser element manufacturing method according to claim 9, wherein
by the step of forming the resonator end surface, the first semiconductor is split into a plurality of base semiconductors, and
a coupler between the base semiconductor and the base substrate is ruptured in selective transfer to the first substrate.

11. The laser element manufacturing method according to any one of claims 2 to 10, wherein some of the plurality of laser bodies remaining on the base substrate after the selective transfer to the first substrate are selectively transferred to a second substrate.

12. The laser element manufacturing method according to any one of claims 2 to 11, wherein
the first semiconductor comprises a GaN-based semiconductor, and
the base substrate comprises a main substrate made of a material with a thermal expansion coefficient smaller than that of the GaN-based semiconductor.

13. The laser element manufacturing method according to claim 12, wherein
the first semiconductor comprises GaN, and
the base substrate comprises a silicon substrate or a silicon carbide substrate.

14. The laser element manufacturing method according to any one of claims 2 to 13, wherein the second semiconductor comprises an active layer and a p-type semiconductor layer.

15. The laser element manufacturing method according to any one of claims 2 to 14, wherein the second semiconductor comprises a ridge.

16. The laser element manufacturing method according to any one of claims 2 to 15, wherein an electrode is formed on the second semiconductor.

17. The laser element manufacturing method according to any one of claims 2 to 16, wherein
the semiconductor substrate comprises a mask having a stripe shape, and
the first semiconductor is positioned on the mask.

18. The laser element manufacturing method according to claim 17, wherein
the mask comprises a mask portion and an opening, and
the plurality of first semiconductors are formed by stopping growth of semiconductor crystals growing and coming close to each other on the mask portion, before the semiconductor crystals are associated with each other.

19. The laser element manufacturing method according to claim 17, wherein
the mask comprises a mask portion and an opening, and
the plurality of first semiconductors are formed by stopping growth of a plurality of semiconductor crystals growing and coming close to each other on the mask portion, before the plurality of semiconductor crystals are associated with each other, and then removing the semiconductor crystals in the opening.

20. The laser element manufacturing method according to claim 17, wherein
the mask comprises a mask portion and an opening, and
the plurality of first semiconductors are formed by stopping growth of semiconductor crystals growing and coming close to each other on the mask portion, after the semiconductor crystals are associated with each other, and then removing the semiconductor crystals in the association portion.

21. The laser element manufacturing method according to claim 17, wherein
the mask comprises a mask portion and an opening, and
the plurality of first semiconductors are formed by stopping growth of semiconductor crystals growing and coming close to each other on the mask portion, after the semiconductor crystals are associated with each other, and then removing the semiconductor crystals in the association portion and the semiconductor crystals in the opening.

22. The laser element manufacturing method according to any one of claims 18 to 21, wherein
each first semiconductor comprises a GaN-based semiconductor, and
in the mask, a plurality of inorganic films having a strip shape and each functioning as the mask portion are arranged in a <11-20> direction of each first semiconductor with a gap functioning as the opening.

23. The laser element manufacturing method according to any one of claims 17 to 22, wherein the mask is removed before selective transfer to the first substrate.

24. The laser element manufacturing method according to any one of claims 2 to 23, wherein the first substrate is divided into a plurality of pieces after the selective transfer to the first substrate.

25. A laser element manufacturing method comprising the steps of:
preparing a semiconductor substrate comprising a base substrate and a plurality of laminate bodies having a bar shape and arranged side by side in a first direction above the base substrate;
transferring the plurality of laminate bodies having a bar shape to a first tape once and then transferring to a second tape;
forming a resonator end surface by splitting each laminate body into a plurality of laser bodies arranged in a second direction orthogonal to the first direction, without dividing the second tape; and
selectively transferring, to a first substrate, some of the plurality of laser bodies obtained from the plurality of laminate bodies.

26. The laser element manufacturing method according to claim 1 or 25, wherein
the base substrate is a crystal growth substrate, and
the semiconductor substrate is prepared in which the plurality of laminate bodies having a bar shape are arranged in the first direction in crystalline bonding with the base substrate.

27. A laser element manufacturing device, wherein each step according to claim 1 or 25 is performed.
